# EUROPEAN PATENT APPLICATION

(11) **EP 4 432 357 A1**
(43) Date of publication of application: **18.09.2024**
(21) Application number: 24159071.0
(22) Date of filing: 22.02.2024
(51) Int. Cl.: H01L 27/02, H01L 23/528, H01L 27/118

(54) **INTEGRATED CIRCUIT INCLUDING BACKSIDE WIRING AND METHOD OF DESIGNING THE INTEGRATED CIRCUIT**

(30) Priority: 08.03.2023 KR 20230030753; 17.07.2023 KR 20230092475
(71) Applicant: Samsung Electronics Co., Ltd., Suwon-si, Gyeonggi-do 16677 (KR)
(72) Inventor: LEE, Dalhee, 16677 Suwon-si, Gyeonggi-do (KR); JEON, Sangjung, 16677 Suwon-si, Gyeonggi-do (KR)
(74) Representative: Kuhnen & Wacker Patent- und Rechtsanwaltsbüro PartG mbB

(57) **Abstract**

An integrated circuit includes a plurality of standard cells on a front surface of a substrate and a backside wiring layer on a back surface of the substrate, where the plurality of standard cells include a first standard cell, the first standard cell includes a first P-type transistor and a first N-type transistor, the backside wiring layer includes a first backside wiring pattern configured to receive a first power supply voltage, and a third backside wiring pattern configured to receive a first ground voltage, and the first standard cell at least partially overlaps the first backside wiring pattern, and the third backside wiring pattern.

## Description

### BACKGROUND

Example embodiments of the disclosure relate to an integrated circuit, and more particularly, to an integrated circuit including backside wiring and a method of designing the integrated circuit.

Due to the requirement of high integration and development in a semiconductor process, the width, distance, and/or height of lines included in an integrated circuit may be reduced, and the effects of parasitic elements of the lines may increase. Additionally, for to obtain reduced power consumption, high operation speed, etc., a power supply voltage of an integrated circuit may be decreased, and thus, the parasitic elements of the lines may have increased effects on the integrated circuit. Therefore, the demand for a method of designing an integrated circuit, in which lines and vias are efficiently routed, has increased.

Information disclosed in this Background section has already been known to or derived by the inventors before or during the process of achieving the embodiments of the present application, or is technical information acquired in the process of achieving the embodiments. Therefore, it may contain information that does not form the prior art that is already known to the public.

### SUMMARY

One or more example embodiments of the disclosure provide an integrated circuit with increased routing resource and improved area efficiency that supplies power to a standard cell using a backside wiring layer, and a method of designing the integrated circuit.

Additional aspects will be set forth in part in the description which follows and, in part, will be apparent from the description, or may be learned by practice of the presented embodiments.

According to an aspect of an example embodiment, an integrated circuit may include a plurality of standard cells on a front surface of a substrate and a backside wiring layer on a back surface of the substrate, where the plurality of standard cells include a first standard cell, the first standard cell includes a first P-type transistor and a first N-type transistor, the backside wiring layer includes a first backside wiring pattern configured to receive a first power supply voltage, a second backside wiring pattern configured to receive a second power supply voltage, and a third backside wiring pattern configured to receive a ground voltage, and the first standard cell at least partially overlaps the first backside wiring pattern, the second backside wiring pattern, and the third backside wiring pattern.

According to an aspect of an example embodiment, an integrated circuit may include a plurality of standard cells on a front surface of a substrate and a backside wiring layer on a back surface of the substrate, where the plurality of standard cells include a first standard cell, the first standard cell includes a first P-type transistor and a first N-type transistor, the backside wiring layer includes a first backside wiring pattern configured to receive a power supply voltage, a second backside wiring pattern configured to receive a first ground supply voltage, and a third backside wiring pattern configured to receive a second ground voltage, and the first standard cell at least partially overlaps the first backside wiring pattern, the second backside wiring pattern, and the third backside wiring pattern.

According to an aspect of an example embodiment, an integrated circuit may include a plurality of standard cells on a front surface of a substrate, a backside wiring layer on a back surface of the substrate, and a first backside via and a second backside via on the backside wiring layer, where the plurality of standard cells include a first standard cell, the first standard cell includes a first P-type transistor and a first N-type transistor, the backside wiring layer includes a first backside wiring pattern configured to receive a power supply voltage and a second backside wiring pattern configured to receive a ground voltage, the first standard cell at least partially overlaps the first backside wiring pattern and the second backside wiring pattern, the first backside wiring pattern is connected to a source/drain area of the first P-type transistor through the first backside via, and the second backside wiring pattern is connected to a source/drain area of the first N-type transistor through the second backside via.

According to an aspect of an example embodiment, an integrated circuit may include a plurality of standard cells on a front surface of a substrate, a backside wiring layer on a back surface of the substrate, and a first backside via and a second backside via on the backside wiring layer, where the plurality of standard cells include a first standard cell, the first standard cell includes a first region in which a first P-type transistor is provided and a second region in which a first N-type transistor is provided, the backside wiring layer includes a first backside wiring pattern configured to receive a first voltage, a second backside wiring pattern configured to receive a second voltage, and a third backside wiring pattern configured to receive a third voltage, the first standard cell overlaps the first backside wiring pattern, the second backside wiring pattern, and the third backside wiring pattern, the first backside wiring pattern is connected to a first source/drain area of the first P-type transistor through the first backside via and the third backside wiring pattern is connected to a second source/drain area of the first N-type transistor through the second backside via.

### BRIEF DESCRIPTION OF DRAWINGS

The above and other aspects, features, and advantages of certain example embodiments of the present disclosure will be more apparent from the following description taken in conjunction with the accompanying drawings, in which:
FIG. 1 is a diagram of an integrated circuit according to an embodiment;
FIG. 2 is a cross-sectional view of the integrated circuit of FIG. 1 according to an embodiment;
FIG. 3 is a diagram of an integrated circuit including a plurality of standard cells, according to an embodiment;
FIG. 4 is a cross-sectional view of the integrated circuit of FIG. 3 according to an embodiment;
FIG. 5A is a circuit diagram of a first standard cell of FIG. 3 according to an embodiment;
FIG. 5B is a diagram of the first standard cell of FIG. 3 according to an embodiment;
FIG. 5C is a diagram of the first standard cell of FIG. 3 according to an embodiment;
FIG. 6A is a circuit diagram of a second standard cell of FIG. 3 according to an embodiment;
FIG. 6B is a diagram of the second standard cell of FIG. 3 according to an embodiment; and
FIG. 6C is a diagram of the second standard cell of FIG. 3 according to an embodiment;
FIG. 7A is a circuit diagram of a third standard cell of FIG. 3 according to an embodiment;
FIG. 7B is a diagram of the third standard cell of FIG. 3 according to an embodiment;
FIG. 7C is a diagram of the third standard cell of FIG. 3 according to an embodiment;
FIG. 8A is a cross-sectional view of the integrated circuit taken along a line X1-X1' of FIG. 7C according to an embodiment;
FIG. 8B is a cross-sectional view of the integrated circuit taken along a line X2-X2' of FIG. 7C according to an embodiment;
FIG. 9 is a diagram of an integrated circuit including a plurality of standard cells, according to an embodiment;
FIG. 10 is a diagram of an integrated circuit according to an embodiment;
FIG. 11 is a cross-sectional view of the integrated circuit of FIG. 10 according to an embodiment;
FIG. 12 is a diagram of an integrated circuit including a plurality of standard cells, according to an embodiment;
FIG. 13 is a cross-sectional view of the integrated circuit of FIG. 12 according to an embodiment;
FIG. 14A is a circuit diagram of a first standard cell of FIG. 12 according to an embodiment;
FIG. 14B is a diagram of the first standard cell of FIG. 12 according to an embodiment;
FIG. 14C is a diagram of the first standard cell of FIG. 12 according to an embodiment;
FIG. 15A is a circuit diagram of a second standard cell of FIG. 12 according to an embodiment;
FIG. 15B is a diagram of the second standard cell of FIG. 12 according to an embodiment;
FIG. 15C is a diagram of the second standard cell of FIG. 12 according to an embodiment;
FIG. 16A is a circuit diagram of a third standard cell of FIG. 12 according to an embodiment;
FIG. 16B is a diagram of the third standard cell of FIG. 12 according to an embodiment;
FIG. 16C is a diagram of the third standard cell of FIG. 12 according to an embodiment;
FIG. 17 is a diagram of an integrated circuit including a plurality of standard cells, according to an embodiment;
FIG. 18 is a diagram of an integrated circuit according to an embodiment;
FIG. 19 is a cross-sectional view of the integrated circuit of FIG. 18 according to an embodiment;
FIG. 20 is a diagram of an integrated circuit including a plurality of standard cells, according to an embodiment;
FIG. 21 is a cross-sectional view of the integrated circuit of FIG. 20 according to an embodiment;
FIG. 22 is a diagram of an integrated circuit according to an embodiment;
FIG. 23 is a diagram of an integrated circuit according to an embodiment;
FIG. 24 is a diagram of an integrated circuit according to an embodiment;
FIG. 25 is a diagram of an integrated circuit according to an embodiment;
FIGS. 26A to 26D are diagrams of devices according to some embodiments;
FIG. 27 is a flowchart of a method of manufacturing an integrated circuit, according to an embodiment;
FIG. 28 is a block diagram of a system-on-chip according to an embodiment; and
FIG. 29 is a block diagram of a computing system including a memory storing a program, according to an embodiment.

### DETAILED DESCRIPTION

Hereinafter, example embodiments of the disclosure will be described in detail with reference to the accompanying drawings. The same reference numerals are used for the same components in the drawings, and redundant descriptions thereof will be omitted. The embodiments described herein are example embodiments, and thus, the disclosure is not limited thereto and may be realized in various other forms.

As used herein, expressions such as "at least one of," when preceding a list of elements, modify the entire list of elements and do not modify the individual elements of the list. For example, the expression, "at least one of a, b, and c," should be understood as including only a, only b, only c, both a and b, both a and c, both b and c, or all of a, b, and c.

It will be understood that when an element or layer is referred to as being "over," "above," "on," "below," "under," "beneath," "connected to" or "coupled to" another element or layer, it can be directly over, above, on, below, under, beneath, connected or coupled to the other element or layer or intervening elements or layers may be present. In contrast, when an element is referred to as being "directly over," "directly above," "directly on," "directly below," "directly under," "directly beneath," "directly connected to" or "directly coupled to" another element or layer, there are no intervening elements or layers present.

In this disclosure, an X-axis direction may be referred to as a first horizontal direction or a first direction, a Y-axis direction may be referred to as a second horizontal direction or a second direction, and a Z-axis direction may be referred to as a vertical direction. A plane including an X axis and a Y axis may be referred to as a horizontal plane. An element relatively more shifted in a +Z-axis direction than other elements may be referred to as being arranged above the other elements, and an element relatively more shifted in a -Z-axis direction than other elements may be referred to as being arranged below the other elements.

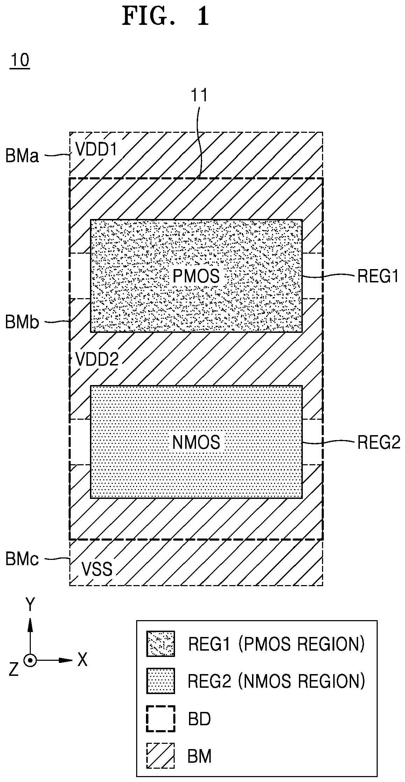

FIG. 1 is a diagram of an integrated circuit 10 according to an embodiment.

Referring to FIG. 1, the integrated circuit 10 may include a standard cell 11 and a backside wiring layer BM. The standard cell 11 may be defined by a cell boundary BD. According to an embodiment, the integrated circuit 10 may be referred to as an "integrated circuit device" or a "semiconductor device." The standard cell 11 is a unit of a layout included in the integrated circuit 10 and may be referred to as a "cell" according to an embodiment. The standard cell 11 may include a transistor and may be designed to perform a pre-defined function. FIG. 1 illustrates the standard cell 11 as a single-height cell. However, the disclosure is not limited thereto, and the standard cell 11 may be realized as a multi-height cell.

The standard cell 11 may include a first region (e.g., a PMOS region) REG1 in which a P-type transistor is arranged and a second region (e.g., an NMOS region) REG2 in which an N-type transistor is arranged. The first and second regions REG1 and REG2 may be arranged on a front surface of a substrate, may each extend in the first (X) direction, and may be spaced apart from each other in the second (Y) direction orthogonal to the first (X) direction. According to an embodiment, the first region REG1 may be referred to as a first active region or a first diffusion region, and the second region REG2 may be referred to as a second active region or a second diffusion region. A region between the first region REG1 and the second region REG2 may be referred to as a dummy region.

The backside wiring layer BM may be arranged on a back surface of the substrate and may supply power to the standard cell 11. For example, the backside wiring layer BM may include a plurality of conductive patterns or patterns including a conductive material. In this disclosure, a "pattern" may refer to a conductive pattern. For example, the backside wiring layer BM may include first to third backside wiring patterns BMa, BMb, and BMc, each of which extends in the first (X) direction, and which are spaced apart from one another in the second (Y) direction. The pattern extending in a direction may be referred to as a line. Thus, the first to third backside wiring patterns BMa to BMc may also be respectively referred to as first to third backside wiring lines. Also, according to an embodiment, the first to third backside wiring patterns BMa to BMc may also be referred to as buried lines or buried wiring patterns. Furthermore, the integrated circuit 10 may further include a front-side wiring layer arranged on the front surface of the substrate to supply a signal to the standard cell 11.

The first to third backside wiring patterns BMa to BMc may be at least partially overlapped by the standard cell 11. For example, the first backside wiring pattern BMa may receive a first voltage (for example, a first power supply voltage VDD1) and may be partially overlapped by the first region REG1. Accordingly, the first backside wiring pattern BMa may be referred to as a first power supply voltage rail or a first power rail. For example, the second backside wiring pattern BMb may receive a second voltage (for example, a second power supply voltage VDD2) and may be partially overlapped by the first and second regions REG1 and REG2. Accordingly, the second backside wiring pattern BMb may be referred to as a second power supply voltage rail or a second power rail. For example, the third backside wiring pattern BMc may receive a third voltage (for example, a ground voltage VSS) and may be partially overlapped by the second region REG2. Accordingly, the third backside wiring pattern BMc may be referred to as a ground voltage rail or a ground rail.

According to an embodiment, the first backside wiring pattern BMa may be partially overlapped by the cell boundary BD (for example, a top boundary) and thus the first backside wiring pattern BMa may be shared by the standard cells adjacent to each other in the second (Y) direction. According to an embodiment, the third backside wiring pattern BMc may be partially overlapped by the cell boundary BD (for example, a bottom boundary), and thus the third backside wiring pattern BMc may be shared by the standard cells adjacent to each other in the second (Y) direction. However, the disclosure is not limited thereto, and at least one of the first and third backside wiring patterns BMa and BMc may not be overlapped by the cell boundary BD (i.e., may not be within the cell boundary BD) and may not be shared by the standard cells adjacent to each other in the second (Y) direction.

A length of each of the first to third backside wiring patterns BMa to BMc in the second (Y) direction (that is, a wiring width of each of the first to third backside wiring patterns BMa to BMc) may be variously changed according to an embodiment. FIG. 1 illustrates that a length of each of the first to third backside wiring patterns BMa to BMc in the first (X) direction (that is, a wiring length of each of the first to third backside wiring patterns BMa to BMc) is the same as a length of the standard cell 11 in the first (X) direction. However, the disclosure is not limited thereto. Each of the first to third backside wiring patterns BMa to BMc may further extend in the first (X) direction, and the length of each of the first to third backside wiring patterns BMa to BMc in the first (X) direction may be greater than the length of the standard cell 11 in the first (X) direction.

According to an embodiment, the first to third backside wiring patterns BMa to BMc may extend in the first (X) direction, and the first to third backside wiring patterns BMa to BMc may be shared by the standard cells adjacent to each other in the first (X) direction. However, the disclosure is not limited thereto, and at least one of the first and third backside wiring patterns BMa and BMc may be arranged as an island type and may not be shared by the standard cells adjacent to each other in the first (X) direction.

According to an embodiment, the first power supply voltage VDD1 may correspond to a virtual power supply voltage or a power supply voltage VDD, and the second power supply voltage VDD2 may correspond to an always-on-power supply voltage or a real power supply voltage VDDG. Accordingly, the first backside wiring pattern BMa receiving the first power supply voltage VDD1 may be referred to as a virtual power line, the second backside wiring pattern BMb receiving the second power supply voltage VDD2 may be referred to as a real power line, and the third backside wiring pattern BMc receiving the ground voltage VSS may be referred to as a ground line. Also, according to an embodiment the first and second backside wiring patterns BMa and BMb may be referred to as buried power rails, and the third backside wiring pattern BMc may be referred to as a buried ground rail.

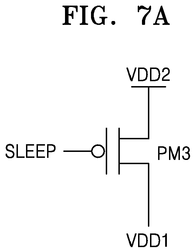

For example, the integrated circuit 10 may selectively connect the second backside wiring pattern BMb to the first backside wiring pattern BMa, in response to a control signal (for example, a control signal SLEEP of FIG. 7A) and may thus selectively transmit the second power supply voltage VDD2 applied to the second backside wiring pattern BMb to the first backside wiring pattern BMa. Accordingly, a driving voltage and a power mode of devices included in the integrated circuit 10 may be adjusted, and thus, power consumption of the integrated circuit 10 may be reduced.

As described above, the integrated circuit 10 may include the plurality of standard cells including the standard cell 11. According to the standard cell method, standard cells having various functions are prepared, and by combining the standard cells, a large-sized integrated circuit according to the specifications of a customer or a user is designed. The standard cell may be designed and verified and may then be registered in a standard cell library, and logic designing, placement, and routing in which the standard cells are combined using a computer aided design (CAD) may be performed to design the integrated circuit 10. When designing the integrated circuit 10, lengths of lines and/or vias and routing complexity may be reduced to further improve the performance of the integrated circuit 10.

According to an embodiment, the integrated circuit 10 may realize a power distribution network (PDN) using the backside wiring layer BM. Thus, power supplies to source/drain areas and/or gate lines may be transmitted through the backside wiring layer BM, and signals applied to the source/drain areas and/or the gate lines may be transmitted through the front-side wiring layer. Therefore, according to an embodiment, compared to a structure in which lines are arranged only on a front surface of a substrate, routing complexity may be significantly reduced and a length of each line or each via may be reduced, and thus, the performance of the integrated circuit 10 may be improved.

Also, according to an embodiment, the first to third backside wiring patterns BMa to BMc of the backside wiring layer BM may have greater widths or heights than the front-side wiring layer, and thus, the resistance of the first to third backside wiring patterns BMa to BMc may be reduced and the voltage drop (e.g., current-resistance (IR) drop) on a chip level may be reduced compared to the related art. Therefore, a power performance area (PPA) of the standard cell 11 or the integrated circuit 10 may further be improved.

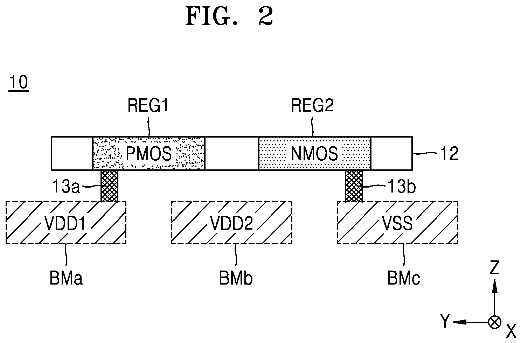

FIG. 2 is a cross-sectional view of the integrated circuit 10 of FIG. 1, according to an embodiment.

Referring to FIGS. 1 and 2 together, a first layer 12 may include a substrate or a semiconductor substrate. For example, the semiconductor substrate may include any one of silicon, a silicon-on-insulator (SOI), silicon-on-sapphire, germanium, silicon-germanium, and gallium-arsenide. However, the disclosure is not limited thereto. According to an embodiment, the first layer 12 may include an insulating layer. For example, in a manufacturing process of the integrated circuit 10, gate lines, source/drain areas, and/or a front-side wiring layer may be formed on the front surface of the substrate to form a device wafer. Next, the device wafer may be temporarily bonded to a carrier wafer and a back-grinding process may be performed on the device wafer. At least a portion of the substrate may be removed by the back-grinding process and an insulating layer may be formed where the at least the portion of the substrate is removed. As described above, the wafer on which the back-grinding process is performed such that a height of the substrate corresponds to a reference height or less (for example, equal to or less than the reference height) may be referred to as a "bulkless wafer" or a "bulkless substrate."

The first region REG1 and the second region REG2 may be arranged on a front surface of the first layer 12. For example, the first layer 12 may be a P-type semiconductor substrate. For example, the first region REG1 may be formed in an N-type well in the P-type semiconductor substrate, and P-type transistors (that is, P-type metal-oxide-semiconductor (MOS) (PMOS) transistors), may be arranged in the first region REG1. For example, the second region REG2 may be formed in the P-type semiconductor substrate, and N-type transistors (that is, N-type MOS (NMOS) transistors) may be arranged in the second region REG2.

For example, the first region REG1 and the second region REG2 may have different conductivity types from each other. The first and second regions REG1 and REG2 may be referred to as diffusion regions. A diffusion region may be a region doped with impurities that change an electrical characteristic of a substrate material and may form source/drain areas of a transistor. A device isolation layer, such as a shallow trench isolation (STI) layer, may be arranged between the first region REG1 and the second region REG2. The first region REG1 and the second region REG2 may be isolated from each other by the device isolation layer.

On a back surface of the first layer 12, the first to third backside wiring patterns BMa, BMb, and BMc may extend in the first (X) direction and may be spaced apart from one another in the second (Y) direction. However, the disclosure is not limited thereto, and extension directions of the first to third backside wiring patterns BMa to BMc may be variously changed according to an embodiment. The first to third backside wiring patterns BMa to BMc may include doped polysilicon, metals, conductive metal nitride, conductive metal carbide, conductive metal silicide, or a combination thereof. For example, the first to third backside wiring patterns BMa to BMc may include Al, Cu, Ti, Ta, W, Mo, TaN, NiSi, CoSi, TiN, WN, TiAl, TiAIN, TaCN, TaC, TaSiN, or a combination thereof but are not limited thereto.

A backside via 13a may be arranged on the first backside wiring pattern BMa and may extend in the vertical (Z) direction. For example, the backside via 13a may pass through the first layer 12 and may be connected to a source/drain area of the first region REG1. Thus, the backside via 13a may connect the first backside wiring pattern BMa to the P-type transistor in the first region REG1. For example, a lower surface of the backside via 13a may contact the first backside wiring pattern BMa, and an upper surface of the backside via 13a may be connected to the source/drain area of the P-type transistor in the first region REG1. Thus, the first power supply voltage VDD1 applied to the first backside wiring pattern BMa may be directly transmitted to the source/drain area of the P-type transistor.

A backside via 13b may be arranged on the third backside wiring pattern BMc and may extend in the vertical (Z) direction. For example, the backside via 13b may pass through the first layer 12 and may be connected to a source/drain area of the second region REG2. Thus, the backside via 13b may connect the third backside wiring pattern BMc to the N-type transistor in the second region REG2. For example, a lower surface of the backside via 13b may contact the third backside wiring pattern BMc, and an upper surface of the backside via 13c may be connected to the source/drain area of the N-type transistor in the second region REG2. Thus, the ground voltage VSS applied to the third backside wiring pattern BMc may be directly transmitted to the source/drain area of the N-type transistor.

As described above, the backside vias 13a and 13b may be arranged on the backside wiring layer BM and may connect layers and elements on the back surface of the substrate to elements, for example, diffusion regions in the substrate. For example, the backside vias 13a and 13b may be directly connected to the first and second regions REG1 and REG2 of the standard cell 11. As described above, a structure in which a via or a contact is connected below epitaxial areas, such as source/drain areas, may be referred to as a direct backside contact (DBC). According to an embodiment, the DBC may include a backside contact and/or a backside via.

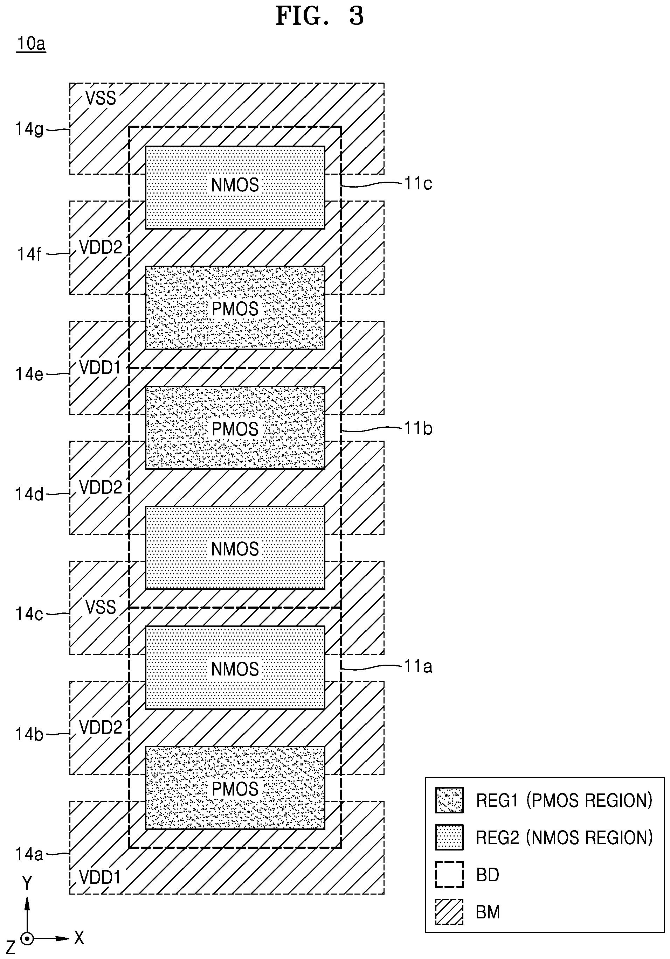

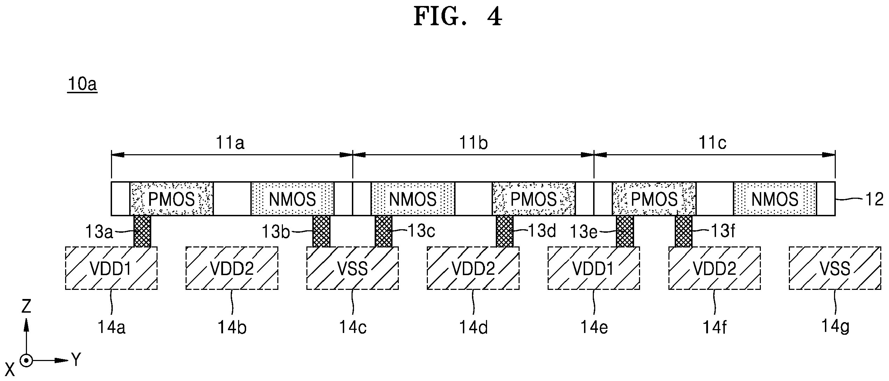

FIG. 3 is a diagram of an integrated circuit 10a including a plurality of standard cells, according to an embodiment. FIG. 4 is a cross-sectional view of the integrated circuit 10a of FIG. 3 according to an embodiment.

Referring to FIGS. 3 and 4 together, the integrated circuit 10a may include first to third standard cells 1 1a, 11b, and 11c arranged on a front surface of a substrate in a second (Y) direction. Each of the first to third standard cells 11a, 11b, and 11c may include the first region REG1 and the second region REG2. For example, at least one of the first to third standard cells 11a to 11c may be designed as a power gating cell, and thus, the integrated circuit 10a may have a power gating structure including the power gating cell. The integrated circuit 10a may correspond to an embodiment of the integrated circuit 10 illustrated in FIGS. 1 and 2, and the detailed aspects described with reference to FIGS. 1 and 2 may be applied to the present embodiment.

The integrated circuit 10a may further include a backside wiring layer BM arranged on the back surface of the substrate. The backside wiring layer BM may include a plurality of backside wiring patterns 14a to 14g. The plurality of backside wiring patterns 14a to 14g may each extend in a first (X) direction and may be spaced apart from one another in the second (Y) direction. For example, the backside wiring patterns 14a and 14e may receive a first power supply voltage VDD1, the backside wiring patterns 14b, 14d, and 14f may receive a second power supply voltage VDD2, and the backside wiring patterns 14c and 14g may receive a ground voltage.

The first standard cell 1 1a may at least partially overlap the backside wiring patterns 14a, 14b, and 14c. The second standard cell 11b may at least partially overlap the backside wiring patterns 14c, 14d, and 14e. The third standard cell 11c may at least partially overlap the backside wiring patterns 14e, 14f, and 14g. The backside wiring pattern 14c may be overlapped by the first and second standard cells 11a and 11b and may be shared by the first and second standard cells 11a and 11b. Also, the backside wiring pattern 14e may be overlapped by the second and third standard cells 11b and 11c and may be shared by the second and third standard cells 11b and 11c. As described above, each of the first to third standard cells 1 1a, 11b, and 11c may overlap three backside wiring patterns.

The integrated circuit 10a may further include backside vias 13a to 13f. The backside via 13a may be arranged on the backside wiring pattern 14a, and the backside wiring pattern 14a may transmit the first power supply voltage VDD1 to a source/drain area of a P-type transistor through the backside via 13a. The backside via 13b may be arranged on the backside wiring pattern 14c, and the backside wiring pattern 14c may transmit the ground voltage VSS to a source/drain area of an N-type transistor through the backside via 13b. The backside via 13c may be arranged on the backside wiring pattern 14c, and the backside wiring pattern 14c may transmit the ground voltage VSS to a source/drain area of an N-type transistor through the backside via 13c.

The backside via 13d may be arranged on the backside wiring pattern 14d, and the backside wiring pattern 14d may transmit the second power supply voltage VDD2 to a source/drain area of a P-type transistor through the backside via 13d. The backside via 13f may be arranged on the backside wiring pattern 14f, and the backside wiring pattern 14f may transmit the second power supply voltage VDD2 to a first source/drain area (for example, the source area) of a P-type transistor through the backside via 13f. The backside via 13e may be arranged on the backside wiring pattern 14e, and the backside wiring pattern 14e may be connected to a second source/drain area (for example, the drain area) of the P-type transistor through the backside via 13e.

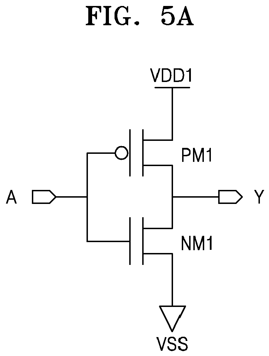

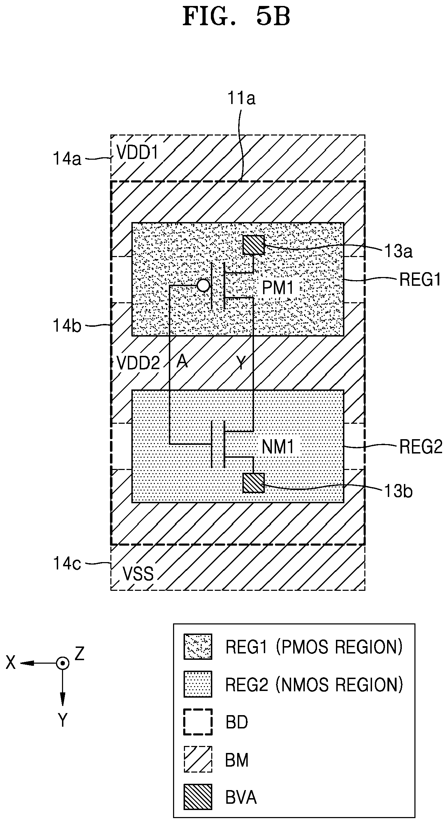

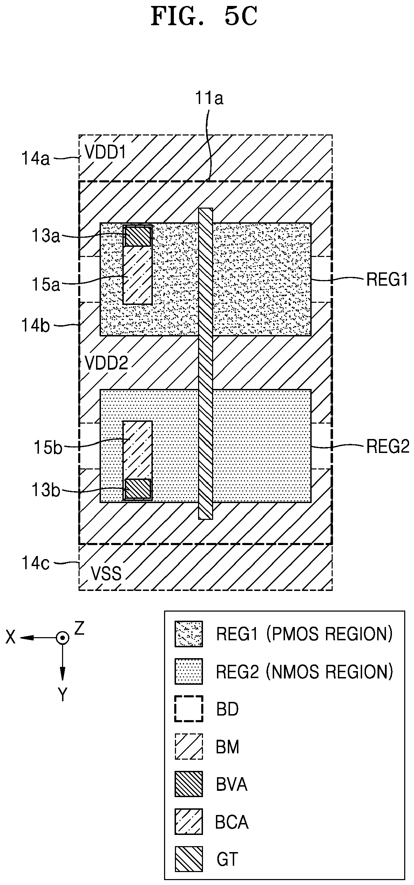

FIG. 5A is a circuit diagram of the first standard cell 11a of FIG. 3 according to an embodiment, FIG. 5B is a diagram of the first standard cell 11a of FIG. 3 according to an embodiment, and FIG. 5C is a diagram of the first standard cell 11a of FIG. 3 according to an embodiment.

Referring to FIG. 5A, the first standard cell 11a may be designed as an inverter cell including a P-type transistor PM1 and an N-type transistor NM1 connected in series with each other. The P-type transistor PM1 may include a source receiving the first power supply voltage VDD1, a gate connected to an input node A, and a drain connected to an output node Y. The N-type transistor NM1 may include a source receiving the ground voltage VSS, a gate connected to the input node A, and a drain connected to the output node Y.

Referring to FIG. 5B, the P-type transistor PM1 may be arranged in the first region REG1, and the N-type transistor NM1 may be arranged in the second region REG2. A source of the P-type transistor PM1 may be connected to the backside wiring pattern 14a through a DBC (for example, the backside via 13a), and may thus receive the first power supply voltage VDD1 from the backside wiring pattern 14a. A source of the N-type transistor NM1 may be connected to the backside wiring pattern 14c through a DBC (for example, the backside via 13b), and may thus receive the ground voltage VSS from the backside wiring pattern 14c.

Referring to FIG. 5C, the first standard cell 11a may include a gate line GT extending in the second (Y) direction across the first and second regions REG1 and REG2. Also, the first standard cell 11a may further include backside vias BVA arranged on the backside wiring layer BM and backside contacts BCA arranged on the backside vias BVA. The backside vias BVA may include the backside via 13a in the first region REG1 and the backside via 13b in the second region REG2. The backside contacts BCA may include a backside contact 15a on the backside via 13a and a backside contact 15b on the backside via 13b.

Thus, the backside wiring pattern 14a may be connected to the first region REG1 through the backside via 13a and the backside contact 15a and may thus transmit the first power supply voltage VDD1 to a source/drain area of the P-type transistor PM1 arranged in the first region REG1. Also, the backside wiring pattern 14c may be connected to the second region REG2 through the backside via 13b and the backside contact 15b and may thus transmit the ground voltage VSS to a source/drain area of the N-type transistor NM1 arranged in the second region REG2.

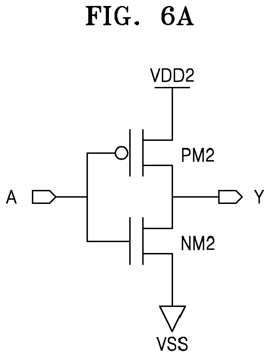

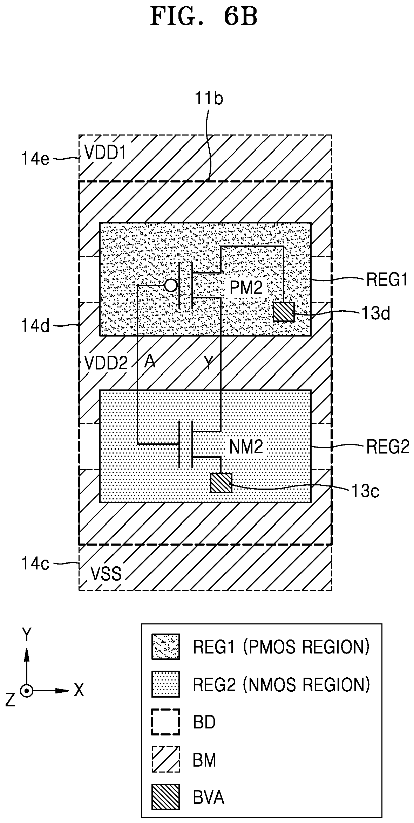

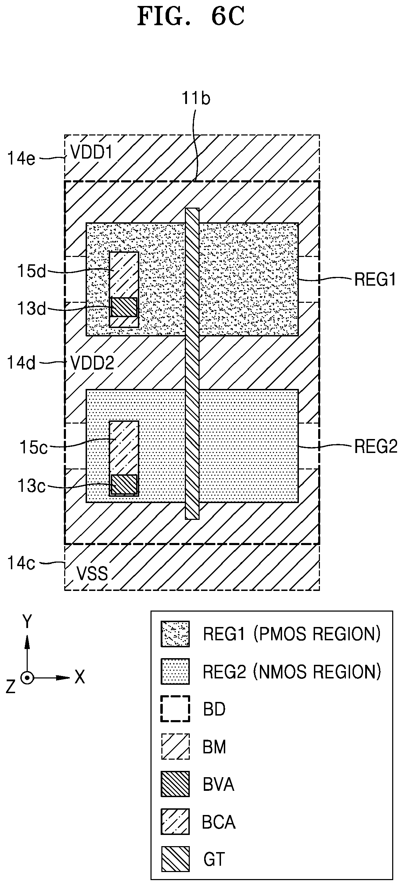

FIG. 6A is a circuit diagram of the second standard cell 11b of FIG. 3 according to an embodiment, FIG. 6B is a diagram of the second standard cell 11b of FIG. 3 according to an embodiment, and FIG. 6C is a diagram of the second standard cell 11b of FIG. 3 according to an embodiment.

Referring to FIG. 6A, the second standard cell 11b may be designed as an inverter cell including a P-type transistor PM2 and an N-type transistor NM2 connected in series with each other. The P-type transistor PM2 may include a source receiving the second power supply voltage VDD2, a gate connected to an input node A, and a drain connected to an output node Y. The N-type transistor NM2 may include a source receiving the ground voltage VSS, a gate connected to the input node A, and a drain connected to the output node Y.

Referring to FIG. 6B, the P-type transistor PM2 may be arranged in the first region REG1, and the N-type transistor NM2 may be arranged in the second region REG2. The source of the P-type transistor PM2 may be connected to the backside wiring pattern 14d through a DBC (for example, the backside via 13d), and may thus receive the second power supply voltage VDD2 from the backside wiring pattern 14d. The source of the N-type transistor NM2 may be connected to the backside wiring pattern 14c through a DBC (for example, the backside via 13c), and may thus receive the ground voltage VSS from the backside wiring pattern 14c.

Referring to FIG. 6C, the second standard cell 11b may include a gate line GT extending in the second (Y) direction across the first and second regions REG1 and REG2. Also, the second standard cell 11b may further include backside vias BVA arranged on the backside wiring layer BM and backside contacts BCA arranged on the backside vias BVA. The backside vias BVA may include the backside via 13d in the first region REG1 and the backside via 13c in the second region REG2. The backside contacts BCA may include a backside contact 15d on the backside via 13d and a backside contact 15c on the backside via 13c.

Thus, the backside wiring pattern 14d may be connected to the first region REG1 through the backside via 13d and the backside contact 15d and may thus transmit the second power supply voltage VDD2 to a source/drain area of the P-type transistor PM2 arranged in the first region REG1. Also, the backside wiring pattern 14c may be connected to the second region REG2 through the backside via 13c and the backside contact 15c and may thus transmit the ground voltage VSS to a source/drain area of the N-type transistor NM2 arranged in the second region REG2.

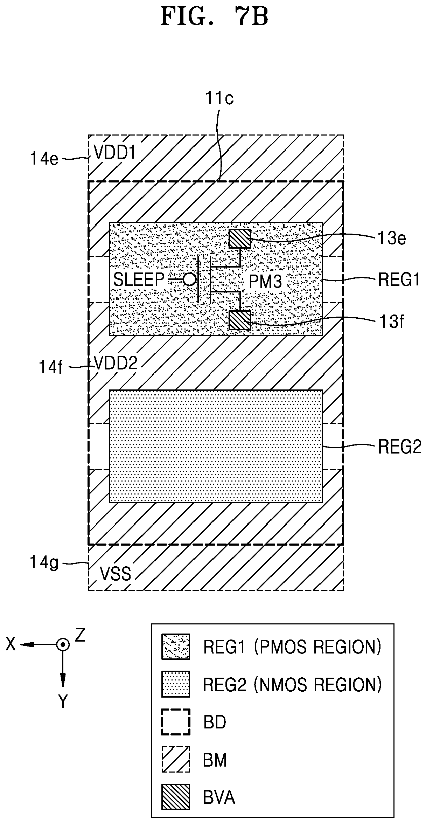

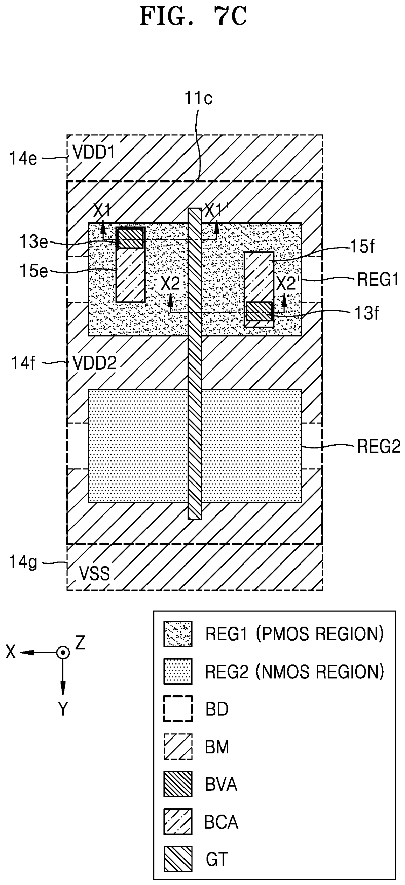

FIG. 7A is a circuit diagram of the third standard cell 11c of FIG. 3 according to an embodiment, FIG. 7B is a diagram of the third standard cell 11c of FIG. 3 according to an embodiment, and FIG. 7C is a diagram of the third standard cell 11c of FIG. 3 according to an embodiment.

Referring to FIG. 7A, the third standard cell 11c may be designed as a "power gating cell" including a P-type transistor PM3. The P-type transistor PM3 may include a source connected to a second power supply voltage terminal, a gate configured to receive a control signal SLEEP, and a drain connected to a first power supply voltage terminal. Thus, the P-type transistor PM3 may be referred to as a sleep control transistor. For example, the second power supply voltage VDD2 may be a real power supply voltage, and the first power supply voltage VDD1 may be a virtual power supply voltage. The P-type transistor PM3 may connect the second power supply voltage terminal with the first power supply voltage terminal in response to the control signal SLEEP and may thus supply the real power supply voltage to the first power supply voltage terminal.

Referring to FIG. 7B, the P-type transistor PM3 may be arranged in the first region REG1. The source of the P-type transistor PM3 may be connected to the backside wiring pattern 14f through a DBC (for example, the backside via 13f), and may thus receive the second power supply voltage VDD2 from the backside wiring pattern 14f. The drain of the P-type transistor PM3 may be connected to the backside wiring pattern 14e through a DBC (for example, the backside via 13e).

Referring to FIG. 7C, the third standard cell 11c may include a gate line GT extending in the second (Y) direction across the first and second regions REG1 and REG2. Also, the third standard cell 11c may further include backside vias BVA arranged on the backside wiring layer BM and backside contacts BCA arranged on the backside vias BVA. The backside vias BVA may include the backside vias 13e and 13f in the first region REG1. The backside contacts BCA may include a backside contact 15e on the backside via 13e and a backside contact 15f on the backside via 13f.

Thus, the backside wiring pattern 14f may be connected to the first region REG1 through the backside via 13f and the backside contact 15f and may thus transmit the second power supply voltage VDD2 to a source area of the P-type transistor PM3 arranged in the first region REG1. Also, the backside wiring pattern 14e may be connected to the first region REG1 through the backside via 13e and the backside contact 15e. As described above, the backside wiring pattern 14f may be electrically connected to the backside wiring pattern 14e through the P-type transistor PM3 arranged in the first region REG1 and may transmit the second power supply voltage VDD2 as a power supply voltage VDD.

As described above, the integrated circuit 10a may include a power gating circuit including the third standard cell 11c and may thus selectively provide the power supply voltage VDD to the backside wiring pattern 14e from the backside wiring pattern 14f. The power gating circuit including the third standard cell 11c may selectively connect the backside wiring pattern 14f receiving the second power supply voltage VDD2 to the backside wiring pattern 14e in response to a control signal SLEEP and may thus adjust a driving voltage provided to the integrated circuit 10a and adjust a power mode of the integrated circuit 10a.

For example, in a power-on mode, the third standard cell 11c may electrically connect the backside wiring patterns 14e and 14f and may thus provide the second power supply voltage VDD2 to the integrated circuit 10a as a power supply voltage. Thus, in the power-on mode, devices included in the integrated circuit 10a may operate according to the power supply voltage. For example, in a power-off mode, the third standard cell 11c may block (that is, electrically insulate) the backside wiring patterns 14e and 14f from each other and may thus float the backside wiring pattern 14e. Thus, in the power-off mode, devices included in the integrated circuit 10a may not operate and power consumption of the integrated circuit 10a may be reduced.

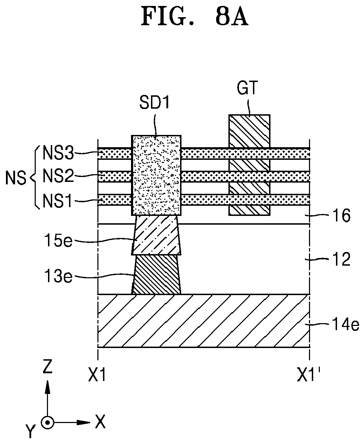

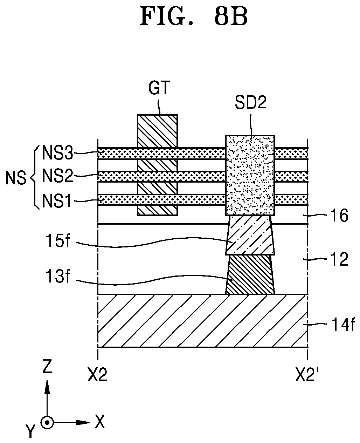

FIG. 8A is a cross-sectional view of the integrated circuit 10a taken along a line X1-X1' of FIG. 7C according to an embodiment, and FIG. 8B is a cross-sectional view of the integrated circuit 10a taken along a line X2-X2' of FIG. 7C according to an embodiment.

Referring to FIGS. 8A and 8B together, a nanosheet stack NS extending in a first (X) direction may be arranged above the first layer 12. The nanosheet stack NS may include a plurality of nanosheets, namely, first to third nanosheets NS1 to NS3, sequentially overlapping in a vertical (Z) direction. For example, the nanosheet stack NS arranged on an N well may be doped with N-type impurities and may form a P-type transistor. However, the nanosheet stack NS arranged on a P-type substrate may be doped with P-type impurities and may form an N-type transistor. According to an embodiment, the nanosheet stack NS may include Si, Ge, or SiGe. According to an embodiment, the nanosheet stack NS may include InGaAs, InAs, GaSb, InSb, or a combination thereof. An interlayer insulating layer 16 may be arranged between the first layer 12 and the first nanosheet NS1 and between the first to third nanosheets NS1 to NS3.

A gate line GT may cover or at least partially cover the nanosheet stack NS and may surround or at least partially surround each of the first to third nanosheets NS1 to NS3. Thus, the first to third nanosheets NS1 to NS3 may have a gate-all-around (GAA) structure. A gate insulating layer may be arranged between the gate line GT and the first to third nanosheets NS1 to NS3. The gate line GT may include, for example, a metal material, such as W, Ta, etc., nitride of the metal materials, silicide of the metal materials, doped polysilicon, etc. and may be formed using, for example, a deposition process. Source/drain areas SD1 and SD2 may be arranged at both sides of the gate line GT. For example, the source/drain areas SD1 and SD2 may include an epitaxial area of a semiconductor material.

According to an embodiment, recess areas, extending into the active region (for example, the first region REG1) at both sides of the gate line GT, may be formed, and the source/drain areas SD1 and SD2 may be formed in the recess areas. Each of the source/drain areas SD1 and SD2 may be formed in the recess area and may have a plurality of inclined sidewalls. Each of the source/drain areas SD1 and SD2 may include a doped SiGe layer, a doped Ge layer, a doped SiC layer, or a doped InGaAs layer but is not limited thereto. As described above, the recess areas may be formed by removing portions of the first region REG1 at both sides of the gate line GT, and a semiconductor layer filling the recess areas may be grown by an epitaxial process, to form the source/drain areas SD1 and SD2.

The backside via 13e may be arranged on the backside wiring pattern 14e, and the backside contact 15e may be arranged on the backside via 13e. The backside contact 15e may be electrically connected to the source/drain area SD1, and thus, the backside via 13e and/or the backside contact 15e may correspond to a DBC. The backside via 13f may be arranged on the backside wiring pattern 14f, and the backside contact 15f may be arranged on the backside via 13f. The backside contact 15f may be electrically connected to the source/drain area SD2, and thus, the backside via 13f and/or the backside contact 15f may correspond to a DBC. The backside vias 13e and 13f and the backside contacts 15e and 15f may include an arbitrary material having electrical conductivity, for example, W. According to some embodiments, the backside vias 13e and 13f may be arranged under the first layer 12, and the backside contacts 15e and 15f may be arranged on the backside vias 13e and 13f, respectively.

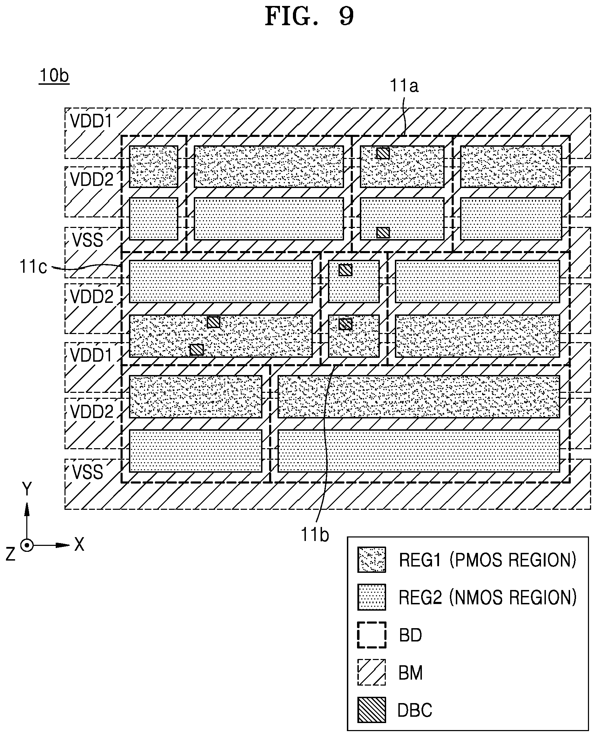

FIG. 9 is a diagram of an integrated circuit 10b including a plurality of standard cells, according to an embodiment.

Referring to FIG. 9, the integrated circuit 10b may include the plurality of standard cells, each of which is defined by a cell boundary BD. For example, the plurality of standard cells may include first to third standard cells 11a, 11b, and 11c. For example, the first to third standard cells 11a to 11c of FIG. 9 may correspond to the first to third standard cells 11a to 11c of FIGS. 3 to 8, respectively. The aspects that are described in detail with reference to FIGS. 3 to 8 may be applied, and repeated descriptions may be omitted.

The integrated circuit 10b may include, on a back surface of a substrate, a backside wiring layer BM including a plurality of backside wiring lines, each of which extends in a first (X) direction, and which are spaced apart from each other in a second (Y) direction. The backside wiring lines overlapped by the first standard cell 11a may receive a first power supply voltage VDD1, a second power supply voltage VDD2, and a ground voltage VSS. A source/drain area of a P-type transistor arranged in a first region REG1 of the first standard cell 11a may receive the first power supply voltage VDD1 through a DBC. A source/drain area of an N-type transistor arranged in a second region REG2 of the first standard cell 11a may receive the ground voltage VSS through the DBC.

The second and third standard cells 11b and 11c may be arranged to be adjacent to each other in the first (X) direction. Accordingly, the backside wiring lines overlapped by the second and third standard cells 11b and 11c may be the same and may receive, for example, the first power supply voltage VDD1, the second power supply voltage VDD2, and the ground voltage VSS. A source/drain area of a P-type transistor arranged in a first region REG1 of the second standard cell 11b may receive the second power supply voltage VDD2 through a DBC. A source/drain area of an N-type transistor arranged in a second region REG2 of the second standard cell 11b may receive the ground voltage VSS through the DBC. A first source/drain area of a P-type transistor arranged in a first region REG1 of the third standard cell 11c (for example, the source area) may receive the second power supply voltage VDD2 through a DBC, and a second source/drain area of the P-type transistor (for example, the drain area) may be electrically connected to the backside wiring layer BM through the DBC (for example, may receive the first power supply voltage VDD1 through the DBC).

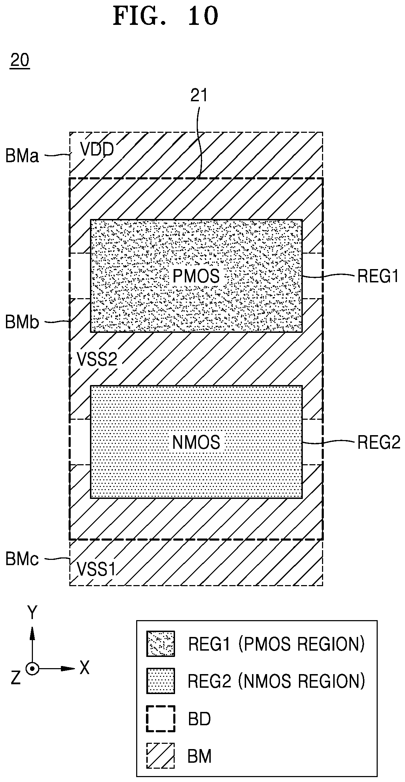

FIG. 10 is a diagram of an integrated circuit 20 according to an embodiment.

Referring to FIG. 10, the integrated circuit 20 may include a standard cell 21 and a backside wiring layer BM, and the backside wiring layer BM may supply power to the standard cell 21. The integrated circuit 20 may correspond to a modified example of the integrated circuit 10 of FIG. 1, the aspects described in detail with reference to FIGS. 1 to 9 may be applied and repeated descriptions may be omitted. Hereinafter, different aspects between the integrated circuit 20 according to an embodiment and the integrated circuit 10 of FIG. 1 are mainly described.

The backside wiring layer BM may include first to third backside wiring patterns BMa, BMb, and BMc, and the first to third backside wiring patterns BMa to BMc may be at least partially overlapped by the standard cell 21. For example, the first backside wiring pattern BMa may receive a first voltage (for example, a power supply voltage VDD) and may be partially overlapped by a first region REG1. Accordingly, the first backside wiring pattern BMa may be referred to as a power supply voltage rail or a power rail. For example, the second backside wiring pattern BMb may receive a second voltage (for example, a second ground voltage VSS2) and may be partially overlapped by the first region REG1 and a second region REG2. Accordingly, the second backside wiring pattern BMb may be referred to as a second ground voltage rail or a second ground rail. For example, the third backside wiring pattern BMc may receive a third voltage (for example, a first ground voltage VSS1) and may be partially overlapped by the second region REG2. Accordingly, the third backside wiring pattern BMc may be referred to as a first ground voltage rail or a first ground rail.

According to an embodiment, the first backside wiring pattern BMa may be partially overlapped by a cell boundary BD (for example, a top boundary), and thus, the first backside wiring pattern BMa may be shared by the standard cells adjacent to each other in a second (Y) direction. According to an embodiment, the third backside wiring pattern BMc may be partially overlapped by the cell boundary BD (for example, a bottom boundary) and thus, the third backside wiring pattern BMc may be shared by the standard cells adjacent to each other in the second (Y) direction. However, the disclosure is not limited thereto, and at least one of the first and third backside wiring patterns BMa and BMc may not be overlapped by the cell boundary BD (i.e., may not be within the cell boundary BD) and may not be shared by the standard cells adjacent to each other in the second (Y) direction.

A length of each of the first to third backside wiring patterns BMa to BMc in the second (Y) direction (that is, a wiring width of each of the first to third backside wiring patterns BMa to BMc) may be variously changed according to an embodiment. FIG. 10 illustrates that a length of each of the first to third backside wiring patterns BMa to BMc in a first (X) direction (that is, a wiring length of each of the first to third backside wiring patterns BMa to BMc) is the same as a length of the standard cell 21 in the first (X) direction. However, the disclosure is not limited thereto. Each of the first to third backside wiring patterns BMa to BMc may further extend in the first (X) direction, and the length of each of the first to third backside wiring patterns BMa to BMc in the first (X) direction may be greater than the length of the standard cell 21 in the first (X) direction.

According to an embodiment, the first to third backside wiring patterns BMa to BMc may extend in the first (X) direction, and thus, the first to third backside wiring patterns BMa to BMc may be shared by the standard cells adjacent to each other in the first (X) direction. However, the disclosure is not limited thereto, and at least one of the first to third backside wiring patterns BMa to BMc may be arranged as an island type and may not be shared by the standard cells adjacent to each other in the first (X) direction.

According to an embodiment, the first ground voltage VSS1 may correspond to a virtual ground voltage or a ground voltage VSS, and the second ground voltage VSS2 may correspond to a real ground voltage VSSG. Accordingly, the third backside wiring pattern BMc receiving the first ground voltage VSS1 may be referred to as a virtual ground line, the second backside wiring pattern BMb receiving the second ground voltage VSS2 may be referred to as a real ground line, and the first backside wiring pattern BMa receiving the power supply voltage VDD may be referred to as a power line.

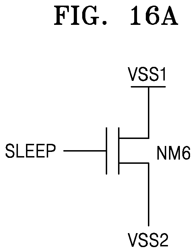

For example, the integrated circuit 20 may selectively connect the second backside wiring pattern BMb to the third backside wiring pattern BMc in response to a control signal (for example, a control signal SLEEP of FIG. 16A) and may thus selectively transmit the second ground voltage VSS2 applied to the second backside wiring pattern BMb to the third backside wiring pattern BMc. Accordingly, a driving voltage and a power mode of devices included in the integrated circuit 20 may be adjusted, and thus, power consumption of the integrated circuit 20 may be reduced.

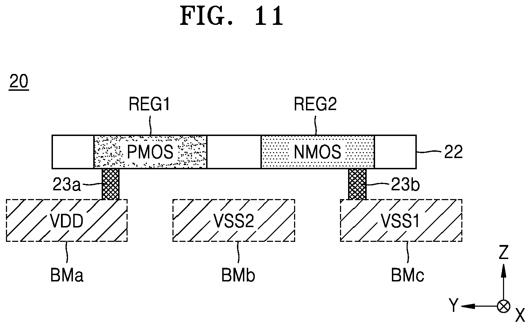

FIG. 11 is a cross-sectional view of the integrated circuit 20 of FIG. 10 according to an embodiment.

Referring to FIGS. 10 and 11 together, a first layer 22 may include a substrate or a semiconductor substrate. For example, the first layer 22 may be implemented to be substantially the same as the first layer 12 of FIG. 2, the aspects described in detail with reference to FIG. 2 may be applied, and repeated descriptions may be omitted. On a back surface of the first layer 22, the first to third backside wiring patterns BMa, BMb, and BMc may extend in the first (X) direction and may be spaced apart from one another in the second (Y) direction.

A backside via 23a may be arranged on the first backside wiring pattern BMa and may extend in a vertical (Z) direction. For example, the backside via 23a may pass through the first layer 22 and may be connected to a source/drain area of the first region REG1. Thus, the backside via 23a may connect the first backside wiring pattern BMa to a P-type transistor in the first region REG1. For example, a lower surface of the backside via 23a may contact the first backside wiring pattern BMa, and an upper surface of the backside via 23a may be connected to the source/drain area of the P-type transistor in the first region REG1. Thus, the power supply voltage VDD applied to the first backside wiring pattern BMa may be directly transmitted to the source/drain area of the P-type transistor.

A backside via 23b may be arranged on the third backside wiring pattern BMc and may extend in the vertical (Z) direction. For example, the backside via 23b may pass through the first layer 22 and may be connected to a source/drain area of the second region REG2. Thus, the backside via 23b may connect the third backside wiring pattern BMc to an N-type transistor in the second region REG2. For example, a lower surface of the backside via 23b may contact the third backside wiring pattern BMc, and an upper surface of the backside via 23b may be connected to the source/drain area of the N-type transistor in the second region REG2. Thus, the first ground voltage VSS1 applied to the third backside wiring pattern BMc may be directly transmitted to the source/drain area of the N-type transistor.

As described above, the backside vias 23a and 23b may be arranged on the backside wiring layer BM and may connect layers and elements on the back surface to elements (for example, diffusion regions) in the substrate. For example, the backside vias 23a and 23b may be directly connected to the first and second regions REG1 and REG2 of the standard cell 21. As described above, a structure in which a via or a contact is connected below epitaxial areas, such as source/drain areas, may be referred to as a DBC. According to an embodiment, the DBC may include a backside contact and/or a backside via.

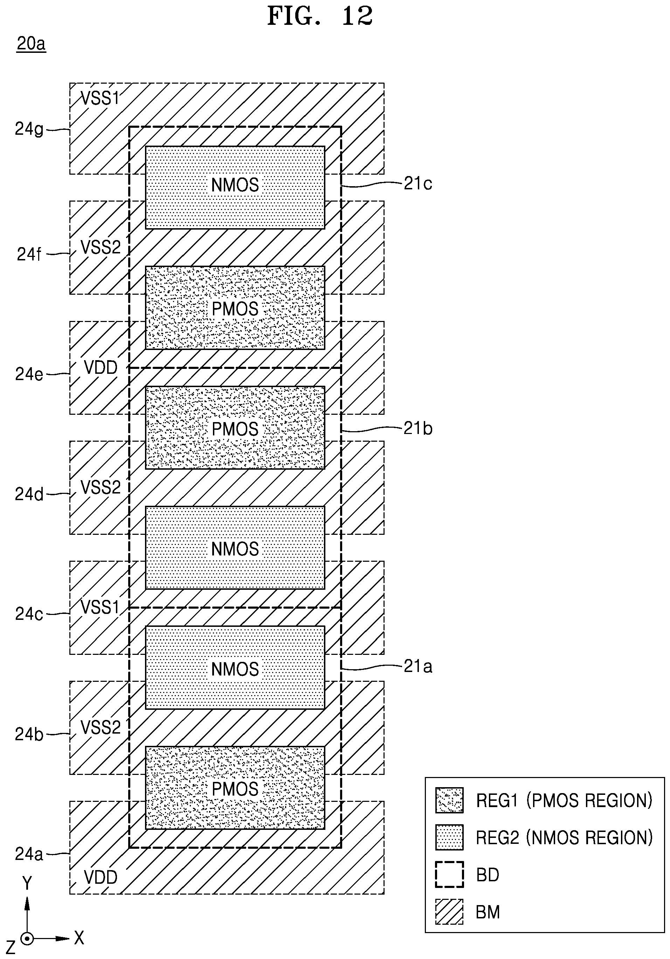

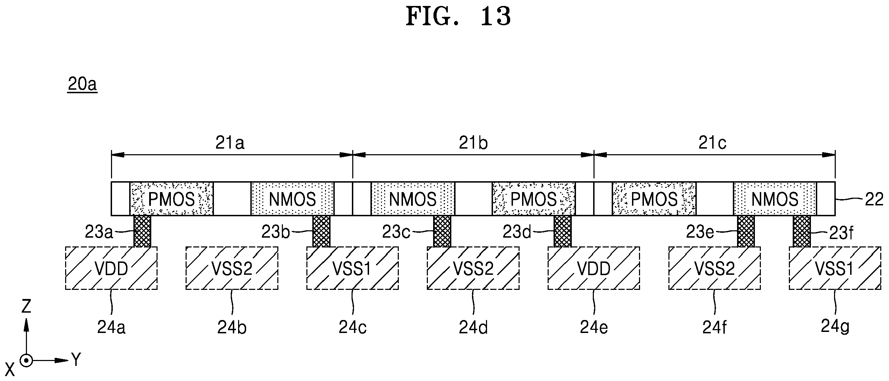

FIG. 12 is a diagram of an integrated circuit 20a including a plurality of standard cells, according to an embodiment. FIG. 13 is a cross-sectional view of the integrated circuit 20a of FIG. 12 according to an embodiment.

Referring to FIGS. 12 and 13 together, the integrated circuit 20a may include first to third standard cells 21a to 21c arranged on a front surface of a substrate and a backside wiring layer BM arranged on a back surface of the substrate. For example, the first to third standard cells 21a to 21c may be arranged in series in a second (Y) direction. Each of the first to third standard cells 21a, 21b, and 21c may include a first region REG1 and a second region REG2. The backside wiring layer BM may include a plurality of backside wiring patterns 24a to 24g. The plurality of backside wiring patterns 24a to 24g may each extend in a first (X) direction and may be spaced apart from one another in the second (Y) direction. For example, the backside wiring patterns 24a and 24e may receive a power supply voltage VDD, the backside wiring patterns 24b, 24d, and 24f may receive a second ground voltage VSS2, and the backside wiring patterns 24c and 24g may receive a first ground voltage VSS1.

The backside wiring patterns 24a, 24b, and 24c may be at least partially overlapped by the first standard cell 21a. The backside wiring patterns 24c, 24d, and 24e may be at least partially overlapped by the second standard cell 21b. The backside wiring patterns 24e, 24f, and 24g may be at least partially overlapped by the third standard cell 21c. Also, the backside wiring pattern 24c may be overlapped by the first and second standard cells 21a and 21b, and the backside wiring pattern 24e may be overlapped by the second and third standard cells 21b and 21c. As described above, each of the first to third standard cells 21a, 21b, and 21c may overlap three backside wiring patterns.

The integrated circuit 20a may further include backside vias 23a to 23f. The backside via 23a may be arranged on the backside wiring pattern 24a, and the backside wiring pattern 24a may transmit the power supply voltage VDD to a source/drain area of a P-type transistor through the backside via 23a. The backside via 23b may be arranged on the backside wiring pattern 24c, and the backside wiring pattern 24c may transmit the first ground voltage VSS1 to a source/drain area of an N-type transistor through the backside via 23b. The backside via 23c may be arranged on the backside wiring pattern 24d, and the backside wiring pattern 24d may transmit the second ground voltage VSS2 to the source/drain area of the N-type transistor through the backside via 23c.

The backside via 23d may be arranged on the backside wiring pattern 24e, and the backside wiring pattern 24e may transmit the power supply voltage VDD to the source/drain area of the P-type transistor through the backside via 23d. The backside via 23e may be arranged on the backside wiring pattern 24f, and the backside wiring pattern 24f may transmit the second ground voltage VSS2 to a first source/drain area (for example, the source area) of the N-type transistor through the backside via 23e. The backside via 23f may be arranged on the backside wiring pattern 24g, and the backside wiring pattern 24g may be connected to a second source/drain area (for example, the drain area) of the N-type transistor through the backside via 23f.

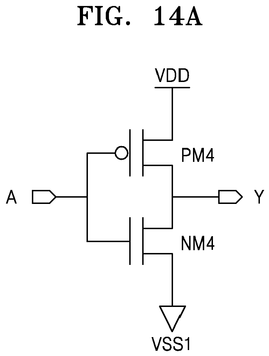

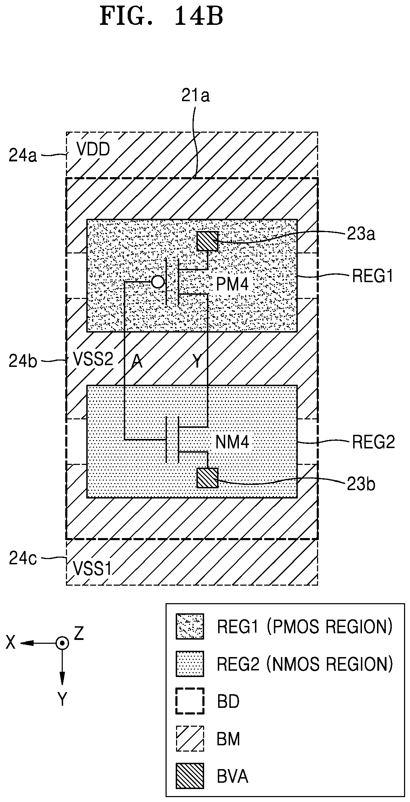

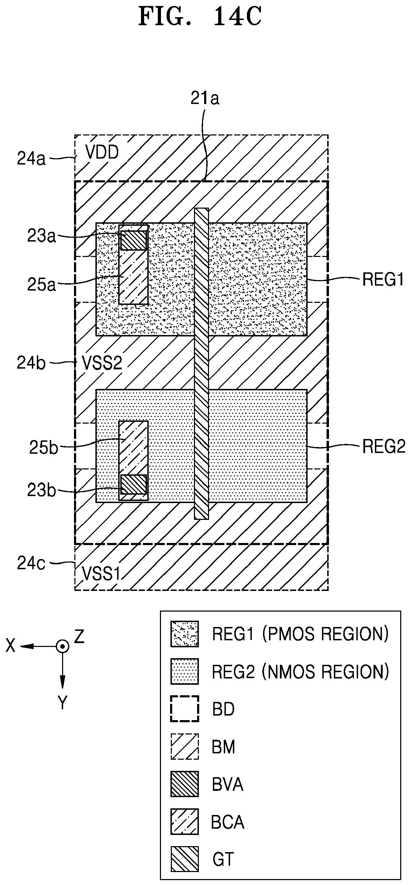

FIG. 14A is a circuit diagram of the first standard cell 21a of FIG. 12 according to an embodiment, FIG. 14B is a diagram of the first standard cell 21a of FIG. 12 according to an embodiment, and FIG. 14C is a diagram of the first standard cell 21a of FIG. 12 according to an embodiment.

Referring to FIG. 14A, the first standard cell 21a may be designed as an inverter cell including a P-type transistor PM4 and an N-type transistor NM4 connected in series with each other. The P-type transistor PM4 may include a source receiving the power supply voltage VDD, a gate connected to an input node A, and a drain connected to an output node Y. The N-type transistor NM4 may include a source receiving the first ground voltage VSS1, a gate connected to the input node A, and a drain connected to the output node Y.

Referring to FIG. 14B, the P-type transistor PM4 may be arranged in the first region REG1, and the N-type transistor NM4 may be arranged in the second region REG2. The source of the P-type transistor PM4 may be connected to the backside wiring pattern 24a through a DBC (for example, the backside via 23a) and may thus receive the power supply voltage VDD from the backside wiring pattern 24a. The source of the N-type transistor NM4 may be connected to the backside wiring pattern 24c through a DBC (for example, the backside via 23b) and may thus receive the first ground voltage VSS1 from the backside wiring pattern 24c.

Referring to FIG. 14C, the first standard cell 21a may include a gate line GT extending in the second (Y) direction across the first and second regions REG1 and REG2. Also, the first standard cell 21a may further include backside vias BVA arranged on the backside wiring layer BM and backside contacts BCA arranged on the backside vias BVA. The backside vias BVA may include the backside via 23a in the first region REG1 and the backside via 23b in the second region REG2. The backside contacts BCA may include a backside contact 25a on the backside via 23a and a backside contact 25b on the backside via 23b.

Thus, the backside wiring pattern 24a may be connected to the first region REG1 through the backside via 23a and the backside contact 25a and may thus transmit the power supply voltage VDD to a source/drain area of the P-type transistor PM4 arranged in the first region REG1. Also, the backside wiring pattern 24c may be connected to the second region REG2 through the backside via 23b and the backside contact 25b and may thus transmit the first ground voltage VSS1 to a source/drain area of the N-type transistor NM4 arranged in the second region REG2.

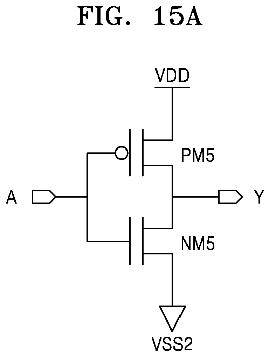

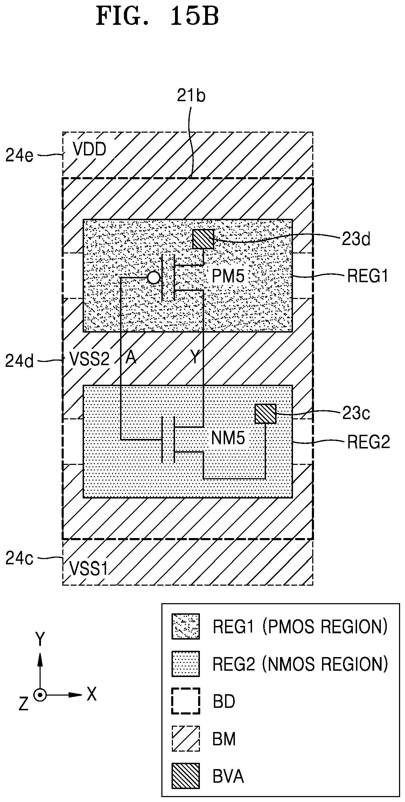

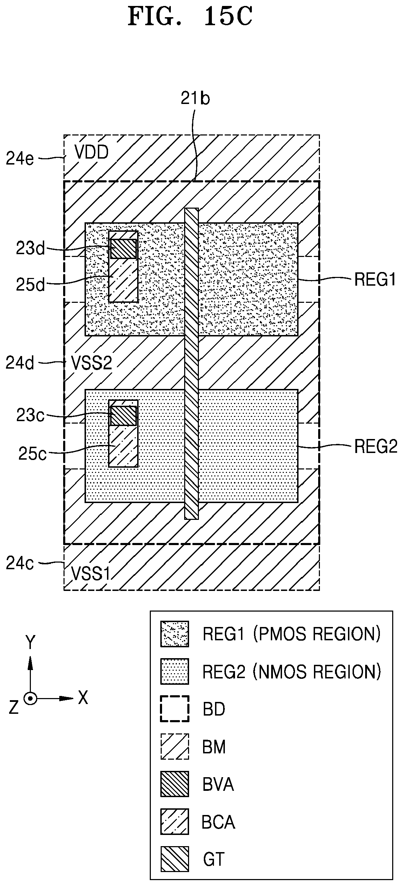

FIG. 15A is a circuit diagram of the second standard cell 21b of FIG. 12 according to an embodiment, FIG. 15B is a layout diagram of the second standard cell 21b of FIG. 12 according to an embodiment, and FIG. 15C is a diagram of the second standard cell 21b of FIG. 12 according to an embodiment.

Referring to FIG. 15A, the second standard cell 21b may be designed as an inverter cell including a P-type transistor PM5 and an N-type transistor NM5 connected in series with each other. The P-type transistor PM5 may include a source receiving the power supply voltage VDD, a gate connected to an input node A, and a drain connected to an output node Y. The N-type transistor NM5 may include a source receiving the second ground voltage VSS2, a gate connected to the input node A, and a drain connected to the output node Y.

Referring to FIG. 15B, the P-type transistor PM5 may be arranged in the first region REG1, and the N-type transistor NM5 may be arranged in the second region REG2. The source of the P-type transistor PM5 may be connected to the backside wiring pattern 24e through a DBC (for example, the backside via 23d) and may thus receive the power supply voltage VDD from the backside wiring pattern 24e. The source of the N-type transistor NM5 may be connected to the backside wiring pattern 24d through a DBC (for example, the backside via 23c) and may thus receive the second ground voltage VSS2 from the backside wiring pattern 24d.

Referring to FIG. 15C, the second standard cell 21b may include a gate line GT extending in the second (Y) direction across the first and second regions REG1 and REG2. Also, the second standard cell 21b may further include backside vias BVA arranged on the backside wiring layer BM and backside contacts BCA arranged on the backside vias BVA. The backside vias BVA may include the backside via 23d in the first region REG1 and the backside via 23c in the second region REG2. The backside contacts BCA may include a backside contact 25d on the backside via 23d and a backside contact 25c on the backside via 23c.

Thus, the backside wiring pattern 24e may be connected to the first region REG1 through the backside via 23d and the backside contact 25d and may thus transmit the power supply voltage VDD to a source/drain area of the P-type transistor PM5 arranged in the first region REG1. Also, the backside wiring pattern 24d may be connected to the second region REG2 through the backside via 23c and the backside contact 25c and may thus transmit the second ground voltage VSS2 to a source/drain area of the N-type transistor NM5 arranged in the second region REG2.

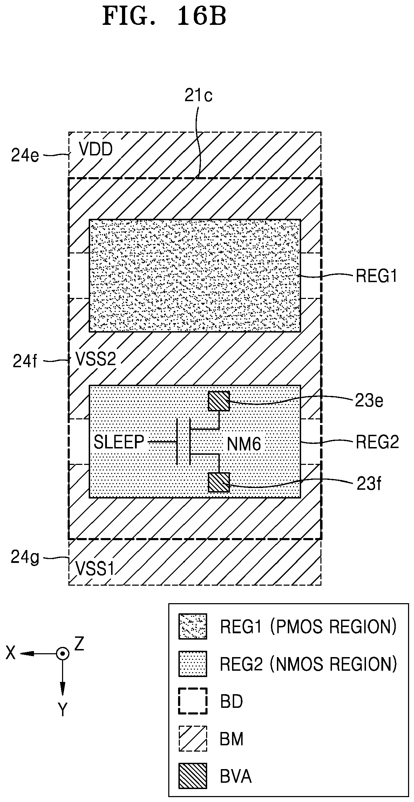

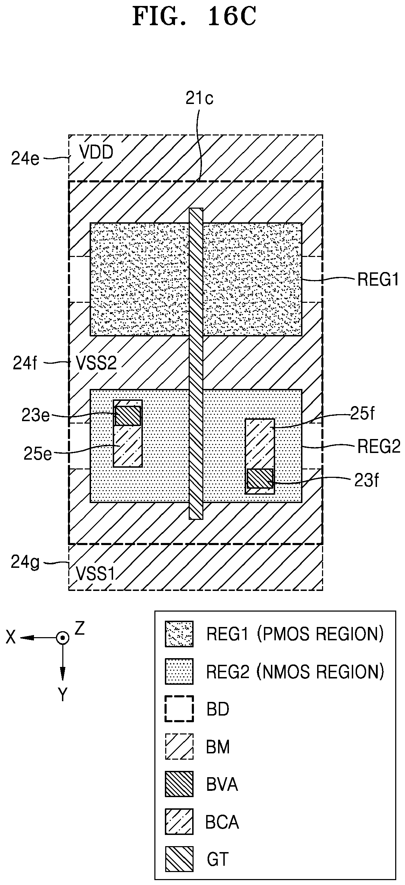

FIG. 16A is a circuit diagram of the third standard cell 21c of FIG. 12 according to an embodiment, FIG. 16B is a diagram of the third standard cell 21c of FIG. 12 according to an embodiment, and FIG. 16C is a diagram of the third standard cell 21c of FIG. 12 according to an embodiment.

Referring to FIG. 16A, the third standard cell 21c may be designed as a power gating cell including an N-type transistor NM6. The N-type transistor NM6 may include a source connected to a second ground voltage terminal, a gate configured to receive a control signal SLEEP, and a drain connected to a first ground voltage terminal. Thus, the N-type transistor NM6 may be referred to as a sleep control transistor. For example, the second ground voltage VSS2 may be a real ground voltage, and the first ground voltage VSS1 may be a virtual ground voltage. The N-type transistor NM6 may connect the second ground voltage terminal with the first ground voltage terminal in response to the control signal SLEEP and may thus supply the real ground voltage to the first ground voltage terminal.

Referring to FIG. 16B, the N-type transistor NM6 may be arranged in the second region REG2. The source of the N-type transistor NM6 may be connected to the backside wiring pattern 24f through a DBC (for example, the backside via 23e) and may thus receive the second ground voltage VSS2 from the backside wiring pattern 24f. The drain of the N-type transistor NM6 may be connected to the backside wiring pattern 24g through a DBC (for example, the backside via 23f).

Referring to FIG. 16C, the third standard cell 21c may include a gate line GT extending in the second (Y) direction across the first and second regions REG1 and REG2. Also, the third standard cell 21c may further include backside vias BVA arranged on the backside wiring layer BM and backside contacts BCA arranged on the backside vias BVA. The backside vias BVA may include the backside vias 23e and 23f in the second region REG2. The backside contacts BCA may include a backside contact 25e on the backside via 23e and a backside contact 25f on the backside via 23f.

Thus, the backside wiring pattern 24f may be connected to the second region REG2 through the backside via 23e and the backside contact 25e and may thus transmit the second ground voltage VSS2 to a source/drain area of the N-type transistor NM6 arranged in the second region REG2. Also, the backside wiring pattern 24g may be connected to the second region REG2 through the backside via 23f and the backside contact 25f. As described above, the backside wiring pattern 24f may be electrically connected to the backside wiring pattern 24g through the N-type transistor NM6 arranged in the second region REG2 and may thus transmit the second ground voltage VSS2 as a ground voltage VSS.

As described above, the integrated circuit 20a may include a power gating circuit including the third standard cell 21c and may thus selectively provide the ground voltage VSS to the backside wiring pattern 24g from the backside wiring pattern 24f. The power gating circuit including the third standard cell 21c may selectively connect the backside wiring pattern 24f receiving the second ground voltage VSS2 to the backside wiring pattern 24g in response to a control signal SLEEP and may thus adjust a driving voltage provided to the integrated circuit 20a and adjust a power mode of the integrated circuit 20a.

For example, in a power-on mode, the third standard cell 21c may electrically connect the backside wiring patterns 24f and 24g and may thus provide the second ground voltage VSS2 to the integrated circuit 20a as a ground voltage. Thus, in the power-on mode, devices included in the integrated circuit 20a may operate. For example, in a power-off mode, the third standard cell 21c may block (that is, electrically insulate) the backside wiring patterns 24f and 24g from each other and may thus float the backside wiring pattern 24g. Thus, in the power-off mode, devices included in the integrated circuit 20a may not operate and power consumption of the integrated circuit 20a may be reduced.

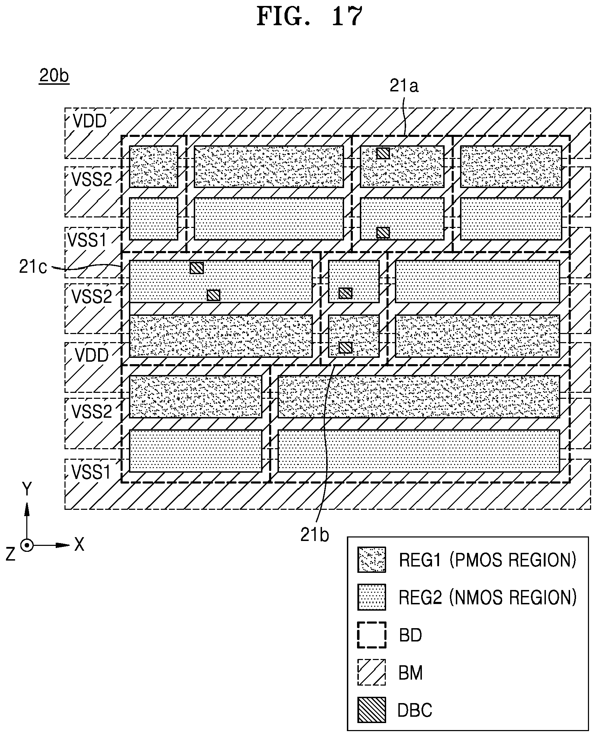

FIG. 17 is a diagram of an integrated circuit 20b including a plurality of standard cells, according to an embodiment.

Referring to FIG. 17, the integrated circuit 20b may include the plurality of standard cells, each of which is defined by a cell boundary BD. For example, the plurality of standard cells may include first to third standard cells 21a, 21b, and 21c. For example, the first to third standard cells 21a to 21c of FIG. 17 may correspond to the first to third standard cells 21a to 21c of FIGS. 12 to 16C, respectively. The aspects that are described in detail with reference to FIGS. 12 to 16C may be applied and repeated descriptions may be omitted.

The integrated circuit 20b may include, on a back surface of a substrate, a backside wiring layer BM including a plurality of backside wiring lines, each of which extends in a first (X) direction, and which are spaced apart from each other in a second (Y) direction. The backside wiring lines overlapped by the first standard cell 21a may receive a power supply voltage VDD, a second ground voltage VSS2, and a first ground voltage VSS1. A source/drain area of a P-type transistor arranged in a first region REG1 of the first standard cell 21a may receive the power supply voltage VDD through a DBC. A source/drain area of an N-type transistor arranged in a second region REG2 of the first standard cell 21a may receive the first ground voltage VSS1 through a DBC.

The second standard cell 21b and the third standard cell 21c may be arranged to be adjacent to each other in the first (X) direction. Accordingly, the backside wiring lines overlapped by the second and third standard cells 21b and 21c may be the same and may receive, for example, the power supply voltage VDD, the second ground voltage VSS2, and the first ground voltage VSS1. A source/drain area of a P-type transistor arranged in a first region REG1 of the second standard cell 21b may receive the power supply voltage VDD through a DBC. A source/drain area of an N-type transistor arranged in a second region REG2 of the second standard cell 21b may receive the second ground voltage VSS2 through a DBC. A first source/drain area, for example, a source area of an N-type transistor arranged in a second region REG2 of the third standard cell 21c may receive the second ground voltage VSS2 through a DBC. A second source/drain area, for example, a drain area of the N-type transistor may be electrically connected to the backside wiring layer BM through a DBC.

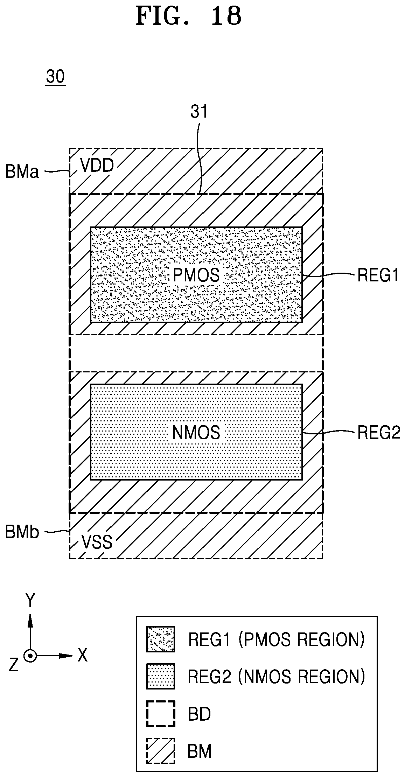

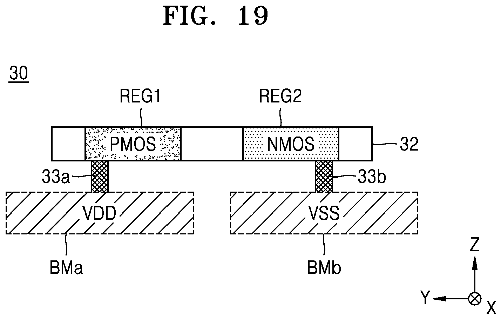

FIG. 18 is a diagram of an integrated circuit 30 according to an embodiment. FIG. 19 is a cross-sectional view of the integrated circuit 30 of FIG. 18 according to an embodiment.

Referring to FIGS. 18 and 19 together, the integrated circuit 30 may include a standard cell 31 and a backside wiring layer BM, and the backside wiring layer BM may supply power to the standard cell 31. The integrated circuit 30 may correspond to a modified example of the integrated circuit 10 of FIG. 1 or the integrated circuit 20 of FIG. 10, the aspects described in detail with reference to FIGS. 1 to 17 may be applied and repeated descriptions may be omitted. Hereinafter, different aspects between the integrated circuit 30 according to an embodiment and the integrated circuit 10 of FIG. 1 or the integrated circuit 20 of FIG. 10 are mainly described.

The backside wiring layer BM may include first and second backside wiring patterns BMa and BMb, and the first and second backside wiring patterns BMa and BMb may be at least partially overlapped by the standard cell 31. For example, the first backside wiring pattern BMa may receive a first voltage (for example, a power supply voltage VDD) and a first region REG1 may be positioned within the width of the first backside wiring pattern BMa in the second (Y) direction. Accordingly, the first backside wiring pattern BMa may be referred to as a power supply voltage rail or a power rail. For example, the second backside wiring pattern BMb may receive a second voltage (for example, a ground voltage VSS) and a second region REG2 may be positioned within the width of the second backside wiring pattern BMb in the second (Y) direction. Accordingly, the second backside wiring pattern BMb may be referred to as a ground voltage rail or a ground rail.

According to an embodiment, the first backside wiring pattern BMa may be partially overlapped by a cell boundary BD (for example, a top boundary), and thus, the first backside wiring pattern BMa may be shared by the standard cells adjacent to each other in a second (Y) direction. According to an embodiment, the second backside wiring pattern BMb may be partially overlapped by the cell boundary BD (for example, a bottom boundary) and thus, the second backside wiring pattern BMb may be shared by the standard cells adjacent in the second (Y) direction. However, the disclosure is not limited thereto, and at least one of the first and second backside wiring patterns BMa and BMb may not be overlapped by the cell boundary BD (i.e., may not be within the cell boundary BD) and may not be shared by the standard cells adjacent to each other in the second (Y) direction.

A length of each of the first and second backside wiring patterns BMa and BMb in the second (Y) direction (that is, a wiring width of each of the first and second backside wiring patterns BMa and BMb) may be variously changed according to an embodiment. FIG. 18 illustrates that a length of each of the first and second backside wiring patterns BMa and BMb in a first (X) direction (that is, a wiring length of each of the first and second backside wiring patterns BMa and BMb) is the same as a length of the standard cell 31 in the first (X) direction. However, the disclosure is not limited thereto. Each of the first and second backside wiring patterns BMa and BMb may further extend in the first (X) direction, and the length of each of the first and second backside wiring patterns BMa and BMb in the first (X) direction may be greater than the length of the standard cell 31 in the first (X) direction.

According to an embodiment, the first and second backside wiring patterns BMa and BMb may extend in the first (X) direction, and thus, the first and second backside wiring patterns BMa and BMb may be shared by the standard cells adjacent to each other in the first (X) direction. However, the disclosure is not limited thereto, and at least one of the first and second backside wiring patterns BMa and BMb may be arranged as an island type and may not be shared by the standard cells adjacent to each other in the first (X) direction.

A first layer 32 may include a substrate or a semiconductor substrate. For example, the first layer 32 may be realized to be substantially the same as the first layer 12 of FIG. 2, and the aspects described in detail with reference to FIG. 2 may be applied to the present embodiment. On a back surface of the first layer 32, the first and second backside wiring patterns BMa and BMb may extend in the first (X) direction and may be spaced apart from one another in the second (Y) direction. However, the disclosure is not limited thereto, and the extension direction of the first and second backside wiring patterns BMa and BMb may be variously changed according to an embodiment.

A backside via 33a may be arranged on the first backside wiring pattern BMa and may extend in a vertical (Z) direction. For example, the backside via 33a may pass through the first layer 32 and may be connected to a source/drain area of a first region REG1. Thus, the backside via 33a may connect the first backside wiring pattern BMa to a P-type transistor in the first region REG1. For example, a lower surface of the backside via 33a may contact the first backside wiring pattern BMa, and an upper surface of the backside via 33a may be connected to the source/drain area of the P-type transistor in the first region REG1. Thus, the power supply voltage VDD applied to the first backside wiring pattern BMa may be directly transmitted to the source/drain area of the P-type transistor.

A backside via 33b may be arranged on the second backside wiring pattern BMb and may extend in the vertical (Z) direction. For example, the backside via 33b may pass through the first layer 32 and may be connected to a source/drain area of a second region REG2. Thus, the backside via 33b may connect the second backside wiring pattern BMb to an N-type transistor in the second region REG2. For example, a lower surface of the backside via 33b may contact the second backside wiring pattern BMb, and an upper surface of the backside via 33b may be connected to the source/drain area of the N-type transistor in the second region REG2. Thus, the ground voltage VSS applied to the second backside wiring pattern BMb may be directly transmitted to the source/drain area of the N-type transistor.

As described above, the backside vias 33a and 33b may be arranged on the backside wiring layer BM and may connect layers and elements on the back surface to elements (for example, diffusion regions) in the substrate. For example, the backside vias 33a and 33b may be directly connected to the first and second regions REG1 and REG2 of the standard cell 31. As described above, a structure in which a via or a contact is connected below epitaxial areas, such as source/drain areas, may be referred to as a DBC. According to an embodiment, the DBC may include a backside contact and/or a backside via.

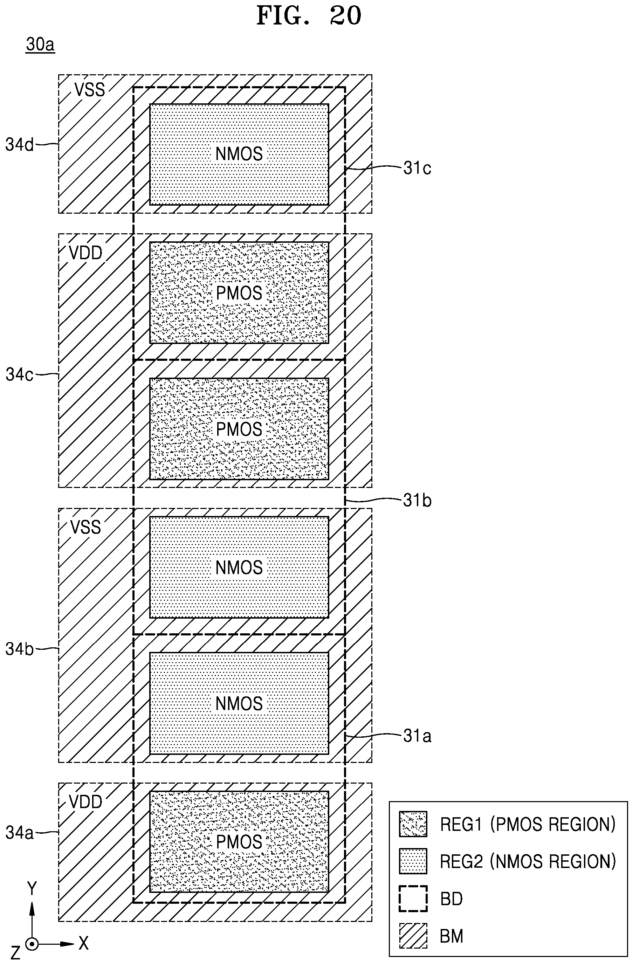

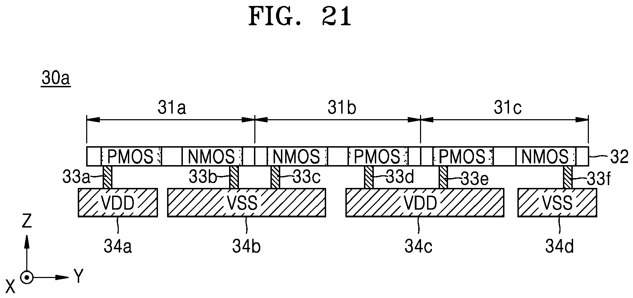

FIG. 20 is a diagram of an integrated circuit 30a including a plurality of standard cells, according to an embodiment. FIG. 21 is a cross-sectional view of the integrated circuit 30a of FIG. 20 according to an embodiment.

Referring to FIGS. 20 and 21 together, the integrated circuit 30a may include first to third standard cells 31a to 31c arranged on a front surface of a substrate and a backside wiring layer BM arranged on a back surface of the substrate. For example, the first to third standard cells 31a to 31c may be arranged in series in a second (Y) direction. Each of the first to third standard cells 31a to 31c may include a first region REG1 and a second region REG2. The backside wiring layer BM may include a plurality of backside wiring patterns 34a to 34d. The plurality of backside wiring patterns 34a to 34d may each extend in a first (X) direction and may be spaced apart from one another in the second (Y) direction. For example, the backside wiring patterns 34a and 34c may receive a power supply voltage VDD, and the backside wiring patterns 34b and 34d may receive a ground voltage VSS.

The backside wiring patterns 34a and 34b may be at least partially overlapped by the first standard cell 31a. The backside wiring patterns 34b and 34c may be at least partially overlapped by the second standard cell 31b. The backside wiring patterns 34c and 34d may be at least partially overlapped by the third standard cell 31c. Also, the backside wiring pattern 34b may be at least partially overlapped by the first and second standard cells 31a and 31b, and the backside wiring pattern 34c may be at least partially overlapped by the second and third standard cells 31b and 31c. As described above, each of the first to third standard cells 31a to 31c may overlap two backside wiring patterns.

The integrated circuit 30a may further include backside vias 33a to 33f. The backside via 33a may be arranged on the backside wiring pattern 34a, and the backside wiring pattern 34a may transmit the power supply voltage VDD to a source/drain area of a P-type transistor through the backside via 33a. The backside via 33b may be arranged on the backside wiring pattern 34b, and the backside wiring pattern 34b may transmit the ground voltage VSS to a source/drain area of an N-type transistor in the first standard cell 31a through the backside via 33b. The backside via 33c may be arranged on the backside wiring pattern 34b, and the backside wiring pattern 34b may transmit the ground voltage VSS to a source/drain area of an N-type transistor in the second standard cell 31b through the backside via 33c.

The backside via 33d may be arranged on the backside wiring pattern 34c, and the backside wiring pattern 34c may transmit the power supply voltage VDD to a source/drain area of a P-type transistor in the second standard cell 3 1b through the backside via 33d. The backside via 33e may be arranged on the backside wiring pattern 34c, and the backside wiring pattern 34c may transmit the power supply voltage VDD to a source/drain area of a P-type transistor in the third standard cell 31c through the backside via 33e. The backside via 33f may be arranged on the backside wiring pattern 34d, and the backside wiring pattern 34d may transmit the ground voltage VSS to a source/drain area of an N-type transistor through the backside via 33f.

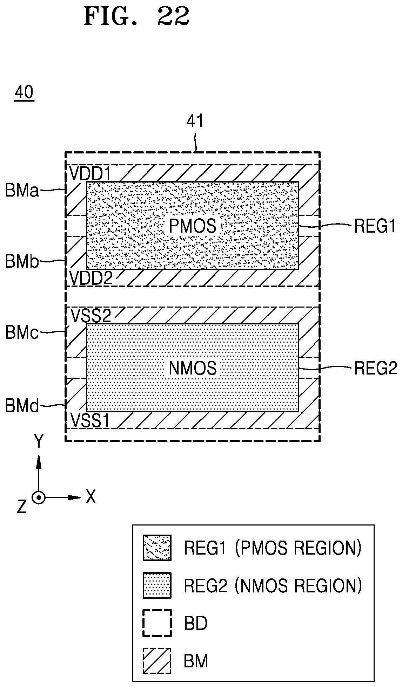

FIG. 22 is a diagram of an integrated circuit 40 according to an embodiment.

Referring to FIG. 22, the integrated circuit 40 may include a standard cell 41 and a backside wiring layer BM, and the backside wiring layer BM may supply power to the standard cell 41. The integrated circuit 40 may correspond to a modified example of the integrated circuit 10 of FIG. 1, the integrated circuit 20 of FIG. 10, or the integrated circuit 30 of FIG. 18, the aspects described above with reference to FIGS. 1 to 21 may be applied and repeated descriptions may be omitted. Hereinafter, different aspects between the integrated circuit 40 according to an embodiment and the integrated circuit 10 of FIG. 1, the integrated circuit 20 of FIG. 10, or the integrated circuit 30 of FIG. 18 are mainly described.

A backside wiring layer BM may include first to fourth backside wiring patterns BMa, BMb, BMc, and BMd, and the first to fourth backside wiring patterns BMa to BMd may be overlapped by the standard cell 41. For example, the first backside wiring pattern BMa may receive a first voltage (for example, a first power supply voltage VDD1) and may be partially overlapped by a first region REG1. Accordingly, the first backside wiring pattern BMa may be referred to as a first power supply voltage rail or a first power rail. For example, the second backside wiring pattern BMb may receive a second voltage (for example, a second power supply voltage VDD2) and may be partially overlapped by the first region REG1. Accordingly, the second backside wiring pattern BMb may be referred to as a second power supply voltage rail or a second power rail. For example, the third backside wiring pattern BMc may receive a third voltage (for example, a second ground voltage VSS2) and may be partially overlapped by a second region REG2. Accordingly, the third backside wiring pattern BMc may be referred to as a second ground voltage rail or a second ground rail. For example, the fourth backside wiring pattern BMd may receive a fourth voltage (for example, a first ground voltage VSS1) and may be partially overlapped by the second region REG2. Accordingly, the fourth backside wiring pattern BMd may be referred to as a first ground voltage rail or a first ground rail.

As described above, the standard cell 41 may overlap four backside wiring patterns (that is, the first to fourth backside wiring patterns BMa to BMd). The first backside wiring pattern BMa may be positioned within a cell boundary BD (for example, a top boundary) and the fourth backside wiring pattern BMd may be positioned within the cell boundary BD (for example, a bottom boundary). Thus, another standard cell adjacent to the standard cell 41 in a second (Y) direction may not share the backside wiring pattern with the standard cell 41.

A length of each of the first to fourth backside wiring patterns BMa to BMd in the second (Y) direction (that is, a wiring width of each of the first to fourth backside wiring patterns BMa to BMd) may be variously changed according to an embodiment. FIG. 22 illustrates that a length of each of the first to fourth backside wiring patterns BMa to BMd in a first (X) direction (that is, a wiring length of each of the first to fourth backside wiring patterns BMa to BMd) is the same as a length of the standard cell 41 in the first (X) direction. However, the disclosure is not limited thereto. Each of the first to fourth backside wiring patterns BMa to BMd may further extend in the first (X) direction, and the length of each of the first to fourth backside wiring patterns BMa to BMd in the first (X) direction may be greater than the length of the standard cell 41 in the first (X) direction.

According to an embodiment, the first to fourth backside wiring patterns BMa to BMd may extend in the first (X) direction, and thus, the first to fourth backside wiring patterns BMa to BMd may be shared by the standard cells adjacent to each other in the first (X) direction. However, the disclosure is not limited thereto, and at least one of the first to fourth backside wiring patterns BMa to BMd may be arranged as an island type and may not be shared by the standard cells adjacent to each other in the first (X) direction.

According to an embodiment, the first power supply voltage VDD1 may correspond to a virtual power supply voltage or a power supply voltage VDD, and the second power supply voltage VDD2 may correspond to a real power supply voltage VDDG. Accordingly, the first backside wiring pattern BMa receiving the first power supply voltage VDD1 may be referred to as a virtual power line, and the second backside wiring pattern BMb receiving the second power supply voltage VDD2 may be referred to as a real power line.

For example, the integrated circuit 40 may selectively connect the second backside wiring pattern BMb to the first backside wiring pattern BMa in response to a control signal (for example, the control signal SLEEP of FIG. 7A) and may thus selectively transmit, as a power supply voltage, the second power supply voltage VDD2 applied to the second backside wiring pattern BMb to the first backside wiring pattern BMa. Accordingly, a driving voltage and a power mode of devices included in the integrated circuit 40 may be adjusted, and thus, power consumption of the integrated circuit 40 may be reduced.

According to an embodiment, the first ground voltage VSS 1 may correspond to a virtual ground voltage or a ground voltage VSS, and the second ground voltage VSS2 may correspond to a real ground voltage VSSG. Accordingly, the fourth backside wiring pattern BMd receiving the first ground voltage VSS1 may be referred to as a virtual ground line, and the third backside wiring pattern BMc receiving the second ground voltage VSS2 may be referred to as a real ground line.

For example, the integrated circuit 40 may selectively connect the third backside wiring pattern BMc to the fourth backside wiring pattern BMd in response to a control signal (for example, the control signal SLEEP of FIG. 16A) and may thus selectively transmit, as a ground voltage, the second ground voltage VSS2 applied to the third backside wiring pattern BMc to the fourth backside wiring pattern BMd. Accordingly, a driving voltage and a power mode of devices included in the integrated circuit 40 may be adjusted, and thus, power consumption of the integrated circuit 40 may be reduced.

The integrated circuit 40 may further include a plurality of DBCs (for example, a plurality of backside vias and/or a plurality of backside contacts) extending on the backside wiring layer BM in a vertical (Z) direction. The plurality of DBCs may include at least one of a first DBC directly connecting the first backside wiring pattern BMa with a source/drain area of the first region REG1, a second DBC directly connecting the second backside wiring pattern BMb with a source/drain area of the first region REG1, a third DBC directly connecting the third backside wiring pattern BMc with a source/drain area of the second region REG2, and a fourth DBC directly connecting the fourth backside wiring pattern BMd with a source/drain area of the second region REG2.

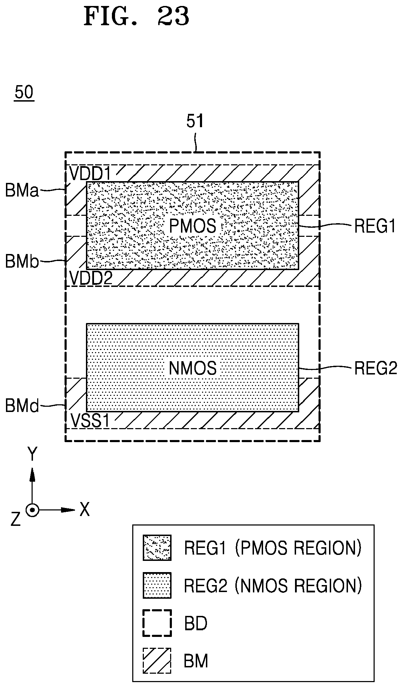

FIG. 23 is a diagram of an integrated circuit 50 according to an embodiment.

Referring to FIG. 23, the integrated circuit 50 may include a standard cell 51 and a backside wiring layer BM, and the backside wiring layer BM may supply power to the standard cell 51. The integrated circuit 50 may correspond to a modified example of the integrated circuit 40 of FIG. 22, the aspects described above with reference to FIG. 22 may be applied and repeated descriptions may be omitted. Hereinafter, different aspects between the integrated circuit 50 according to an embodiment and the integrated circuit 40 of FIG. 22 are mainly described.

The backside wiring layer BM may include first, second, and fourth backside wiring patterns BMa, BMb, and BMd, and the first, second and fourth backside wiring patterns BMa, BMb, and BMd may be overlapped by the standard cell 51. For example, the first backside wiring pattern BMa may receive a first voltage (for example, a first power supply voltage VDD1) and may be partially overlapped by a first region REG1. Accordingly, the first backside wiring pattern BMa may be referred to as a first power supply voltage rail or a first power rail. For example, the second backside wiring pattern BMb may receive a second voltage (for example, a second power supply voltage VDD2) and may be partially overlapped by the first region REG1. Accordingly, the second backside wiring pattern BMb may be referred to as a second power supply voltage rail or a second power rail. For example, the fourth backside wiring pattern BMd may receive a fourth voltage (for example, a first ground voltage VSS1) and may be partially overlapped by a second region REG2. Accordingly, the fourth backside wiring pattern BMd may be referred to as a first ground voltage rail or a first ground rail.

As described above, the standard cell 51 may overlap three backside wiring patterns (that is, the first, second, and fourth backside wiring patterns BMa, BMb, and BMd). The first, second, and fourth backside wiring patterns BMa, BMb, and BMd may each extend in a first (X) direction. The first backside wiring pattern BMa may be positioned within a cell boundary BD (for example, a top boundary) and the fourth backside wiring pattern BMd may be positioned within the cell boundary BD (for example, a bottom boundary). Thus, another standard cell adjacent to the standard cell 51 in a second (Y) direction may not share the backside wiring pattern with the standard cell 51.

The integrated circuit 50 may further include a plurality of DBCs (for example, a plurality of backside vias and/or a plurality of backside contacts) extending on the backside wiring layer BM in a vertical (Z) direction. The plurality of DBCs may include at least one of a first DBC directly connecting the first backside wiring pattern BMa with a source/drain area of the first region REG1, a second DBC directly connecting the second backside wiring pattern BMb with a source/drain area of the first region REG1, and a fourth DBC directly connecting the fourth backside wiring pattern BMd with a source/drain area of the second region REG2.

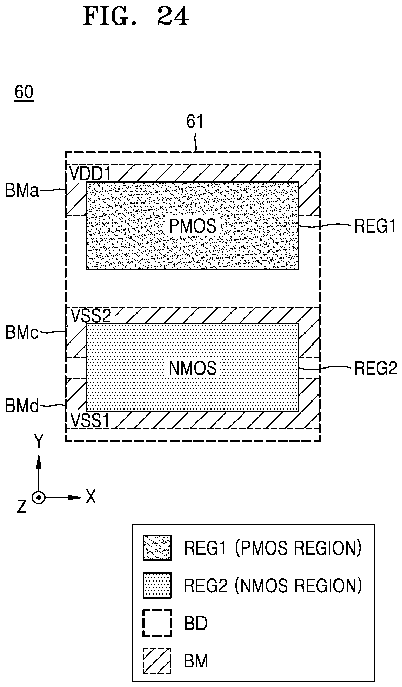

FIG. 24 is a diagram of an integrated circuit 60 according to an embodiment.

Referring to FIG. 24, the integrated circuit 60 may include a standard cell 61 and a backside wiring layer BM, and the backside wiring layer BM may supply power to the standard cell 61. The integrated circuit 60 may correspond to a modified example of the integrated circuit 40 of FIG. 22, the aspects described above with reference to FIG. 22 may be applied and repeated descriptions may be omitted. Hereinafter, different aspects between the integrated circuit 60 according to an embodiment and the integrated circuit 40 of FIG. 22 are mainly described.

The backside wiring layer BM may include first, third, and fourth backside wiring patterns BMa, BMc, and BMd, and the first, third, and fourth backside wiring patterns BMa, BMc, and BMd may be overlapped by the standard cell 61. For example, the first backside wiring pattern BMa may receive a first voltage (for example, a first power supply voltage VDD1) and may be partially overlapped by a first region REG1. Accordingly, the first backside wiring pattern BMa may be referred to as a first power supply voltage rail or a first power rail. For example, the third backside wiring pattern BMc may receive a third voltage (for example, a second ground voltage VSS2) and may be partially overlapped by a second region REG2. Accordingly, the third backside wiring pattern BMc may be referred to as a second ground voltage rail or a second ground rail. For example, the fourth backside wiring pattern BMd may receive a fourth voltage (for example, a first ground voltage VSS1) and may be partially overlapped by the second region REG2. Accordingly, the fourth backside wiring pattern BMd may be referred to as a first ground voltage rail or a first ground rail.

As described above, the standard cell 61 may overlap three backside wiring patterns (that is, the first, third, and fourth backside wiring patterns BMa, BMc, and BMd). The first, third, and fourth backside wiring patterns BMa, BMc, and BMd may each extend in a first (X) direction. The first backside wiring pattern BMa may be positioned within a cell boundary BD (for example, a top boundary) and the fourth backside wiring pattern BMd may be positioned within the cell boundary BD (for example, a bottom boundary). Thus, another standard cell adjacent to the standard cell 61 in a second (Y) direction may not share the backside wiring pattern with the standard cell 61.

The integrated circuit 60 may further include a plurality of DBCs (for example, a plurality of backside vias and/or a plurality of backside contacts) extending on the backside wiring layer BM in a vertical (Z) direction. The plurality of DBCs may include at least one of a first DBC directly connecting the first backside wiring pattern BMa with a source/drain area of the first region REG1, a third DBC directly connecting the third backside wiring pattern BMc with a source/drain area of the second region REG2, and a fourth DBC directly connecting the fourth backside wiring pattern BMd with a source/drain area of the second region REG2.

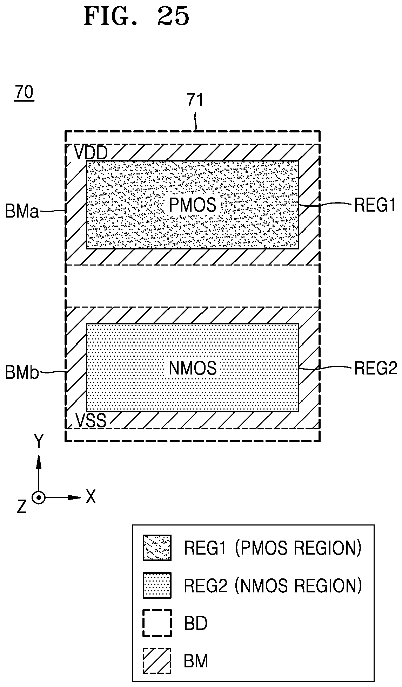

FIG. 25 is a diagram of an integrated circuit 70 according to an embodiment.

Referring to FIG. 25, the integrated circuit 70 may include a standard cell 71 and a backside wiring layer BM, and the backside wiring layer BM may supply power to the standard cell 71. The integrated circuit 70 may correspond to a modified example of the integrated circuit 30 of FIG. 18 or the integrated circuits 40, 50, and 60 of FIGS. 22 to 24, respectively, the aspects described above with reference to FIGS. 18 and 22 to 24 may be applied and repeated descriptions may be omitted. Hereinafter, different aspects between the integrated circuit 70 according to an embodiment and the integrated circuit 30 of FIG. 18 and the integrated circuit 40 of FIG. 22 are mainly described.

The backside wiring layer BM may include first and second backside wiring patterns BMa and BMb, and the first and second backside wiring patterns BMa and BMb may be overlapped by the standard cell 71. For example, the first backside wiring pattern BMa may receive a first voltage (for example, a power supply voltage VDD) and a first region REG1 may be positioned within a width of the first backside wiring pattern BMa in the second (Y) direction. Accordingly, the first backside wiring pattern BMa may be referred to as a power supply voltage rail or a power rail. For example, the second backside wiring pattern BMb may receive a second voltage (for example, a ground voltage VSS) and a second region REG2 may be positioned within a width of the second backside wiring pattern BMb in the second (Y) direction. Accordingly, the second backside wiring pattern BMb may be referred to as a ground voltage rail or a ground rail.

As described above, the standard cell 71 may overlap two backside wiring patterns (that is, the first and second backside wiring patterns BMa and BMb). The first and second backside wiring patterns BMa and BMb may each extend in a first (X) direction. The first backside wiring pattern BMa may be positioned within a cell boundary BD (for example, a top boundary) and the second backside wiring pattern BMb may be positioned within the cell boundary BD (for example, a bottom boundary). The top boundary and the bottom boundary may face each other in a second (Y) direction. Thus, another standard cell adjacent to the standard cell 71 in the second (Y) direction may not share the backside wiring pattern with the standard cell 71.

The integrated circuit 70 may further include a plurality of DBCs (for example, a plurality of backside vias and/or a plurality of backside contacts) extending on the backside wiring layer BM in a vertical (Z) direction. The plurality of DBCs may include at least one of a first DBC directly connecting the first backside wiring pattern BMa with a source/drain area of the first region REG1 and a second DBC directly connecting the second backside wiring pattern BMb with a source/drain area of the second region REG2.

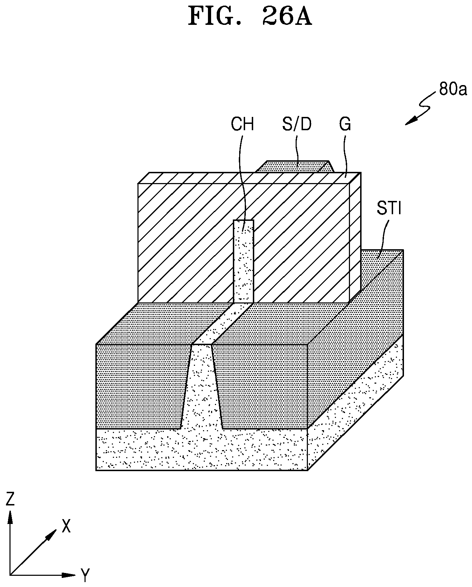

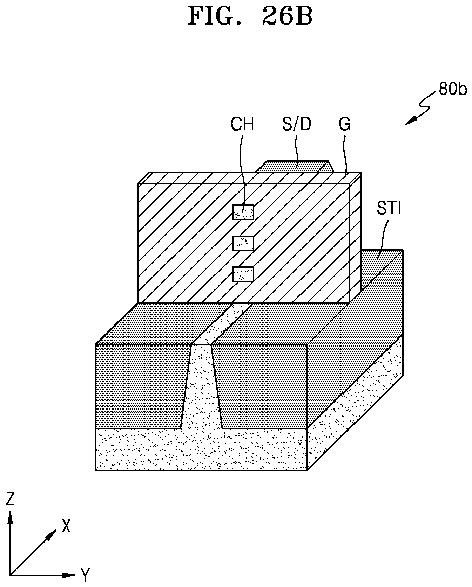

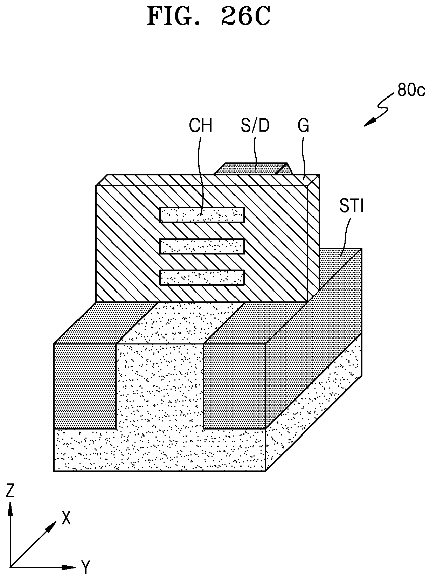

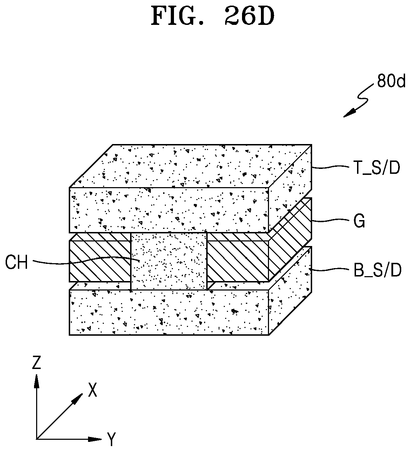

FIGS. 26A to 26D each illustrates a device according to some embodiments. For example, FIG. 26A illustrates a Fin field-effect transistor (FinFET) 80a, FIG. 26B illustrates a GAA field-effect transistor (GAAFET) 80b, FIG. 26C illustrates a multi-bridge channel field-effect transistor (MBCFET^{™}) 80c, and FIG. 26D illustrates a vertical field-effect transistor (VFET) 80d. For convenience of illustration, FIGS. 26A to 26C illustrate a shape in which one of source/drain areas is removed, and FIG. 26D illustrates a cross-section of the VFET 80d taken alone a plane that is parallel with a plane formed by a second (Y) direction and a vertical (Z) direction and passing through a channel CH of the VFET 80d.

Referring to FIG. 26A, the FinFET 80a may be formed by an active pattern having a fin shape extending in a first (X) direction and a gate G extending in a second (Y) direction between STI layers. Source/drains S/D may be formed at both sides of the gate G, and thus, the source/drains S/D may be spaced apart from each other in the first (X) direction. An insulating layer may be formed between a channel CH and the gate G. According to some embodiments, the FinFET 80a may be formed by a plurality of active patterns spaced apart from each other in the second (Y) direction and the gate G. For example, the FinFET 80a may be arranged in the first region REG1 or the second region REG2 of the standard cell 11 of FIG. 1, the standard cell 21 of FIG. 10, the standard cell 31 of FIG. 18, the standard cell 41 of FIG. 22, the standard cell 51 of FIG. 23, the standard cell 61 of FIG. 24, or the standard cell 71 of FIG. 25.

Referring to FIG. 26B, the GAAFET 80b may be formed by active patterns (that is, nanowires) spaced apart from each other in a vertical (Z) direction and extending in a first (X) direction, and a gate G extending in a second (Y) direction. Source/drains S/D may be formed at both sides of the gate G, and thus, the source/drains S/D may be spaced apart from each other in the first (X) direction. An insulating layer may be formed between a channel CH and the gate G. The number of nanowires included in the GAAFET 80b is not limited to the number illustrated in FIG. 26B. For example, the GAAFET 80b may be arranged in the first region REG1 or the second region REG2 of the standard cell 11 of FIG. 1, the standard cell 21 of FIG. 10, the standard cell 31 of FIG. 18, the standard cell 41 of FIG. 22, the standard cell 51 of FIG. 23, the standard cell 61 of FIG. 24, or the standard cell 71 of FIG. 25.

Referring to FIG. 26C, the MBCFET 80c may be formed by active patterns (that is, nanosheets)_spaced apart from each other in a vertical (Z) direction and extending in a first (X) direction, and a gate G extending in a second (Y) direction. Source/drains S/D may be formed at both sides of the gate G, and thus, the source/drains S/D may be spaced apart from each other in the first (X) direction. An insulating layer may be formed between a channel CH and the gate G. The number of nanosheets included in the MBCFET 80c is not limited to the number illustrated in FIG. 26C. For example, the MBCFET 80c may be arranged in the first region REG1 or the second region REG2 of the standard cell 11 of FIG. 1, the standard cell 21 of FIG. 10, the standard cell 31 of FIG. 18, the standard cell 41 of FIG. 22, the standard cell 51 of FIG. 23, the standard cell 61 of FIG. 24, or the standard cell 71 of FIG. 25.

Referring to FIG. 26D, the VFET 80d may include top source/drains T_S/D and bottom source/drains B_S/D spaced apart from each other in a vertical (Z) direction with a channel CH therebetween. The VFET 80d may include a gate G surrounding a circumference of the channel CH between the top source/drains T_S/D and the bottom source/drains B_SD. An insulating layer may be formed between the channel CH and the gate G. For example, the VFET 80d may be arranged in the first region REG1 or the second region REG2 of the standard cell 11 of FIG. 1, the standard cell 21 of FIG. 10, the standard cell 31 of FIG. 18, the standard cell 41 of FIG. 22, the standard cell 51 of FIG. 23, the standard cell 61 of FIG. 24, or the standard cell 71 of FIG. 25.

However, the transistors according to embodiments are not limited to the described structures. For example, an integrated circuit may include a ForkFET having a structure in which nanosheets for a P-type transistor and nanosheets for an N-type transistor are separated from each other by a dielectric wall so that the N-type transistor and the P-type transistor may have a relatively proximate structure. Also, the integrated circuit may not only include the FETs, such as a complementary FET (CFET), a negative capacitance FET (NCFET), and a carbon nanotube FET (CNT FET), but may also include a bipolar junction transistor.

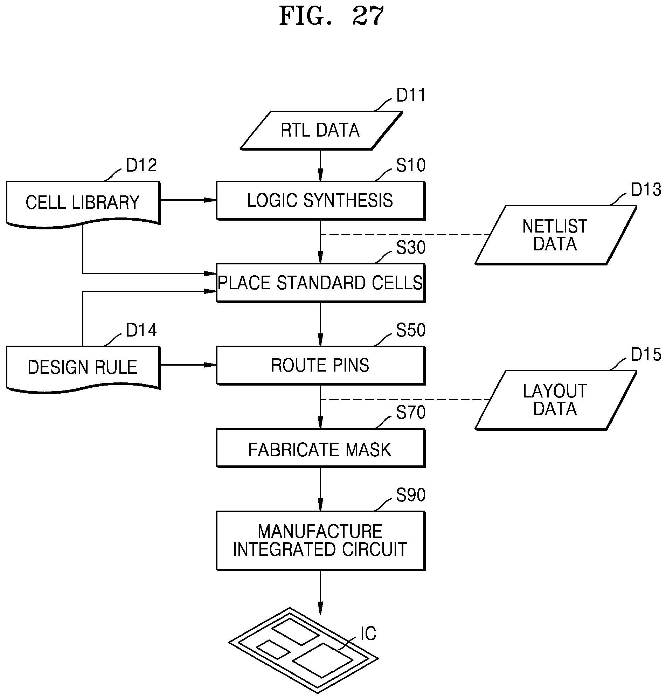

FIG. 27 is a flowchart of a method of manufacturing an integrated circuit, according to an embodiment. Referring to FIG. 27, the method according to an embodiment may correspond to a method of manufacturing an integrated circuit IC including standard cells and may include a plurality of operations S10, S30, S50, S70, and S90. A cell library (or a standard cell library) D12 may include information about the standard cells (for example, information about a function, a characteristic, a layout, etc.). According to some embodiments, the cell library D12 may not only define function cells generating an output signal from an input signal, but may also define a tap cell and a dummy cell. According to some embodiments, the cell library D12 may define memory cells and dummy cells having the same foot prints. A design rule D14 may include requirements to be complied by a layout of the integrated circuit IC. For example, the design rule D14 may include requirements with respect to a space between patterns in the same layer, a minimum width of a pattern, a routing direction of a wiring layer, etc. According to some embodiments, the design rule D14 may define a minimum space in the same track of a wiring layer.

In operation S10, a logic synthesis operation for generating netlist data D13 from register-transfer level (RTL) data D11 may be performed. For example, a semiconductor design tool (for example, a logic synthesis tool) may perform logic synthesis based on the RTL data D11 composed in a hardware description language (HDL), such as a very-high-speed integrated circuit (VHSIC) hardware description language (VHDL) and Verilog, by referring to the cell library D12 and may generate the netlist data D13 including a bitstream or a netlist. The netlist data D13 may correspond to an input of placing and routing described below.

In operation S30, the standard cells may be placed. For example, the semiconductor design tool (for example, a P&R tool) may place the standard cells used in the netlist data D13 with reference to the cell library D12. According to some embodiments, the semiconductor design tool may place the standard cell in a row extending in an X-axis direction or a Y-axis direction, and the placed standard cell may receive power from a power rail extending along boundaries of the row.

For example, the standard cell 11 of FIG. 1 may receive the first power supply voltage VDD1 and the ground voltage VSS respectively from the first and third backside wiring patterns BMa and BMc that are overlapped by the cell boundary BD. For example, the standard cell 21 of FIG. 10 may receive the power supply voltage VDD and the first ground voltage VSS1 respectively from the first and third backside wiring patterns BMa and BMc that are overlapped by the cell boundary BD. For example, the standard cell 31 of FIG. 18 may receive the power supply voltage VDD and the ground voltage VSS respectively from the first and second backside wiring patterns BMa and BMb that are overlapped by the cell boundary BD. For example, the standard cell 41, 51, or 61 of FIG. 22, 23, or 24 may receive the first power supply voltage VDD1 and the first ground voltage VSS1 respectively from the first and fourth backside wiring patterns BMa and BMd. For example, the standard cell 71 of FIG. 25 may receive the power supply voltage VDD and the ground voltage VSS respectively from the first and second backside wiring patterns BMa and BMb.

In operation S50, pins of the standard cells may be routed. For example, the semiconductor design tool may generate interconnections electrically connecting output pins and input pins of the placed standard cells and may generate layout data D15 defining the placed standard cells and the generated interconnections. The interconnection may include a via of a via layer and/or patters of wiring layers. The wiring layers may include a front-side wiring layer arranged above a front surface of a substrate and a backside wiring layer arranged on a back surface of the substrate. The layout data D15 may, for example, have a format such as GDSII and may include geometric information of the cells and the interconnections. The semiconductor design tool may refer to the design rule D14 while routing the pins of the cells. The layout data D15 may correspond to an output of the placing and the routing. Operation S50 may be solely referred to as a method of designing an integrated circuit, or operations S30 and S50 may be collectively referred to as the same.

For example, the integrated circuits 10, 10a, and 10c of FIGS. 1 to 9, the integrated circuits 20, 20a, and 20b of FIGS. 10 to 17, the integrated circuits 30 and 30a of FIGS. 18 to 21, the integrated circuit 40 of FIG. 22, the integrated circuit 50 of FIG. 23, the integrated circuit 60 of FIG. 24, and the integrated circuit 70 of FIG. 25 may include the backside wiring layer BM arranged on the back surface of the substrate, and the backside wiring layer BM may be directly connected to a source/drain area of the standard cell arranged on the front surface of the substrate through the DBC including the backside via BVA and/or the backside contact BCA. Therefore, the routing complexity of the front-side wiring layer arranged on the front surface of the substrate may be reduced, and the IR drop between the backside wiring layer BM and the source/drain area may be reduced.

In operation S70, an operation of fabricating a mask may be performed. For example, optical proximity correction (OPC) for correcting distortion, such as refraction, due to the characteristics of light in photolithography may be applied to the layout data D 15. To form patterns arranged on a plurality of layers based on the data to which the OPC is applied, patterns on a mask may be defined, and at least one mask (or photomask) for forming the patterns of each of the plurality of layers may be fabricated. According to some embodiments, a layout of the integrated circuit IC may be changed in operation S70 in a limited way, and the changing of the integrated circuit IC in the limited way in operation S70 may indicate a post process for optimizing a structure of the integrated circuit IC and may be referred to as design polishing.

In operation S90, an operation of manufacturing the integrated circuit IC may be performed. For example, the plurality of layers may be patterned using the at least one mask fabricated in operation S70 to manufacture the integrated circuit IC. A front-end-of-line (FEOL) may include, for example, planarization and cleaning of a wafer, formation of a trench, formation of a well, formation of a gate line, and formation of a source and a drain. By the FEOL, separate devices, for example, a transistor, a capacitor, a resistor, etc. may be formed on a substrate. Also, a back-end-of-line (BEOL) may include, for example, silicidation of a gate and source and drain areas, addition of a dielectric, planarization, formation of a hole, addition of a metal layer, formation of a via, formation of a passivation layer, etc. By the BEOL, separate devices, for example, a transistor, a capacitor, a resistor, etc. may be interconnected. According to some embodiments, a middle-of-line (MOL) may be performed between the FEOL and the BEOL, and contacts may be formed in the separate devices. Thereafter, the integrated circuit IC may be packaged in a semiconductor package and may be used as a component of various applications.

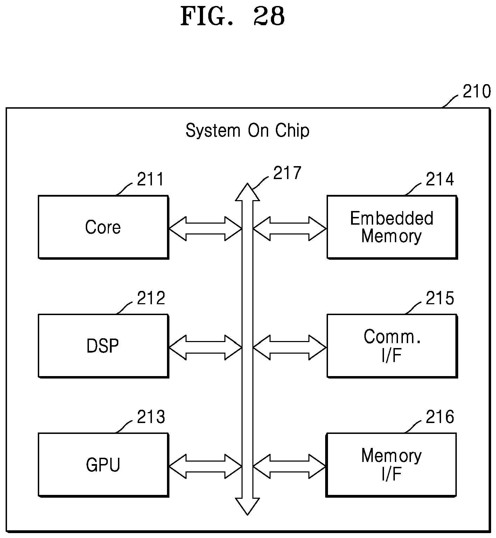

FIG. 28 is a block diagram of a system-on-chip (SoC) 210 according to an embodiment. Referring to FIG. 28, the SoC 210 may refer to an integrated circuit in which components of a computing system or other electronic systems are integrated. For example, an application processor (AP), an example of the SoC 210, may include a processor and components for other functions. The SoC 210 may include a core 211, a digital signal processor (DSP) 212, a graphics processing unit (GPU) 213, an embedded memory 214, a communication interface 215, and a memory interface 216. The components of the SoC 210 may communicate with one another through a bus 217.

The core 211 may be configured to process instructions and control operations of the components included in the SoC 210. For example, the core 211 may be configured to drive an operating system (OS) and execute applications on the OS by processing a series of instructions. The DSP 212 may be configured to generate useful data by processing, for example, a digital signal provided from the communication interface 215. The GPU 213 may be configured to generate data for an image that is output through a display from image data provided from the embedded memory 214 or the memory interface 216, or the GPU 213 may encode the image data. According to some embodiments, the integrated circuits described above with reference to the drawings may be included in the core 211, the DSP 212, the GPU 213, and/or the embedded memory 214.

The embedded memory 214 may store data necessary for the core 211, the DSP 212, and the GPU 213 to operate. The communication interface 215 may provide an interface for a communication network or one-on-one communication. The memory interface 216 may be configured to provide an interface with respect to an external memory of the SoC 210, for example, dynamic random access memory (DRAM), flash memory, etc.

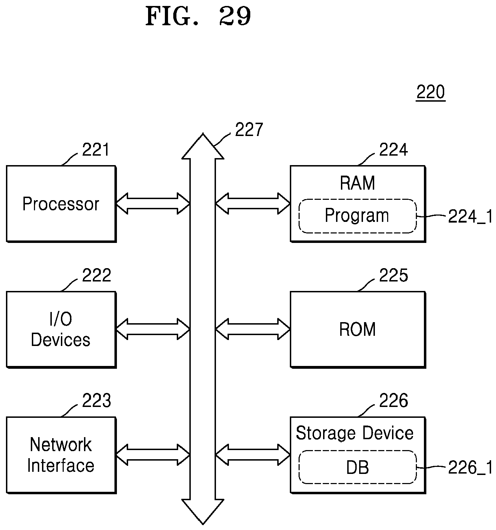

FIG. 29 is a block diagram of a computing system 220 including a memory storing a program, according to an embodiment. Referring to FIG. 29, at least one of the operations of the method of designing the integrated circuit, according to an embodiment, for example, the flowchart described above may be performed by the computing system 220 (or a computer). The computing system 220 may include a processor 221, input and output (I/O) devices 222, a network interface 223, random-access memory (RAM) 224, read-only memory (ROM) 225, and a storage device 226. The processor 221, the input and output devices 222, the network interface 223, the RAM 224, the ROM 225, and the storage device 226 may be connected to a bus 227 and may communicate with one another through the bus 227.

The processor 221 may be referred to as a processing unit and may include at least one core configured to execute an arbitrary instruction set (for example, Intel architecture (IA)-32, 64-bit expansion IA-32, x86-64, PowerPC, Sparc, MIPS, ARM, IA-64, etc.), such as a micro-processor, an AP, a DSP, and a GPU. For example, the processor 221 may access a memory (that is, the RAM 224 or the ROM 225) through the bus 227 and may execute instructions stored in the RAM 224 or the ROM 225.

The RAM 224 may store a program 224_1 for the method of designing the integrated circuit, according to an embodiment, or at least part of the program 224_1, and through the program 224_1, the processor 221 may perform at least one of the operations of the method of designing the integrated circuit (for example, the operations included in the method of FIG. 26). That is, the program 224_1 may include a plurality of instructions executable by the processor 221, and the plurality of instructions included in the program 224_1 may allow the processor 221 to perform at least one of the operations included in the flowcharts described above.

The storage device 226 may not lose data stored even when a power supplied to the computing system 220 is blocked. The storage device 226 may store the program 224_1 according to an embodiment, and before the program 224_1 is executed by the processor 221, the program 224_1 or at least part of the program 224_1 may be loaded from the storage device 226 to the RAM 224. Alternatively, the storage device 226 may store a file composed in a program language, and the program 224_1 generated by a compiler, etc. or at least part of the program 224_1 may be loaded from the file to the RAM 224. Also, the storage device 226 may store a database (DB) 226_1, and the database 226_1 may include information necessary to design an integrated circuit, for example, information with respect to designed blocks, and the cell library D12 and/or the design rule D14 of FIG. 26.

The storage device 226 may store data to be processed by the processor 221 or data processed by the processor 221. That is, the processor 221 may generate data by processing the data stored by the storage device 226 or may store the generated data in the storage device 226, according to the program 224_1. For example, the storage device 226 may store the RTL data D 11, the netlist data D13, and/or the layout data D 15 of FIG. 27.

The input and output devices 222 may include an input device, such as a keyboard, a pointing device, etc., and may include an output device, such as a display device, a printer, etc. For example, a user may trigger execution of the program 224_1 by the processor 221 through the input and output devices 222, may input the RTL data D11 and/or the netlist data D 13 of FIG. 27, and may identify the layout data D 15 of FIG. 27. The network interface 223 may provide access to a network outside the computing system 220. For example, the network may include a plurality of computing systems and communication links, and the communication links may include wired links, optical links, wireless links, or other arbitrary forms of links.

At least one of the devices, units, components, modules, or the like represented by a block or an equivalent indication in the above embodiments including, but not limited to, FIGS. 28 and 29, may be physically implemented by analog and/or digital circuits including one or more of a logic gate, an integrated circuit, a microprocessor, a microcontroller, a memory circuit, a passive electronic component, an active electronic component, an optical component, and the like, and may also be implemented by or driven by software and/or firmware (configured to perform the functions or operations described herein).

Each of the embodiments provided in the above description is not excluded from being associated with one or more features of another example or another embodiment also provided herein or not provided herein but consistent with the disclosure.

While the disclosure has been particularly shown and described with reference to embodiments thereof, it will be understood that various changes in form and details may be made therein without departing from the scope of the following claims.

## Claims

1. An integrated circuit comprising:
a plurality of standard cells on a front surface of a substrate; and
a backside wiring layer on a back surface of the substrate,
wherein the plurality of standard cells comprise a first standard cell,
wherein the first standard cell comprises a first P-type transistor and a first N-type transistor,
wherein the backside wiring layer comprises:
a first backside wiring pattern configured to receive a first power supply voltage; and
a third backside wiring pattern configured to receive a first ground voltage, and
wherein the first standard cell at least partially overlaps the first backside wiring pattern, and the third backside wiring pattern.

2. The integrated circuit of claim 1, further comprising a second backside wiring pattern configured to receive a second power supply voltage, wherein the first standard cell at least partially overlaps the second backside wiring pattern.

3. The integrated circuit of claim 2, wherein the first standard cell shares the first backside wiring pattern with another standard cell that is adjacent to the first standard cell.

4. The integrated circuit of claim 1, comprising:
a second backside wiring pattern configured to receive a second ground voltage;
wherein the first standard cell at least partially overlaps the second backside wiring pattern.

5. The integrated circuit of claim 4, wherein the first standard cell shares the third backside wiring pattern with another standard cell that is adjacent to the first standard cell.

6. The integrated circuit of any one of claims 2 to 5, further comprising:
a first backside via on the first backside wiring pattern; and
a second backside via on the third backside wiring pattern,
wherein the first backside wiring pattern is connected to a source/drain area of the first P-type transistor through the first backside via, and
wherein the third backside wiring pattern is connected to a source/drain area of the first N-type transistor through the second backside via.

7. The integrated circuit of claim 6, further comprising:
a first backside contact on the first backside via; and
a second backside contact on the second backside via,
wherein the first backside wiring pattern is connected to the source/drain area of the first P-type transistor through the first backside via and the first backside contact, and
wherein the third backside wiring pattern is connected to the source/drain area of the first N-type transistor through the second backside via and the second backside contact.

8. The integrated circuit of any one of claims 2 to 7, wherein each of the first backside wiring pattern, the second backside wiring pattern, and the third backside wiring pattern extends in a first direction, and
wherein the first backside wiring pattern, the second backside wiring pattern, and the third backside wiring pattern are spaced apart in a second direction orthogonal to the first direction.

9. The integrated circuit of claim 8, wherein the second backside wiring pattern is between the first backside wiring pattern and the third backside wiring pattern.

10. The integrated circuit of any one of claims 2 to 9, wherein the plurality of standard cells further comprises a second standard cell,
wherein the second standard cell comprises a third transistor,
wherein the backside wiring layer further comprises a fourth backside wiring pattern,
wherein the second standard cell at least partially overlaps the fourth backside wiring pattern, and
wherein the fourth backside wiring pattern is connected to a source/drain area of the third transistor.

11. The integrated circuit of claim 1, further comprising:
a first backside via and a second backside via on the backside wiring layer,
wherein the first backside wiring pattern is connected to a source/drain area of the first P-type transistor through the first backside via, and
wherein the third backside wiring pattern is connected to a source/drain area of the first N-type transistor through the second backside via.
